(19) **Europäisches Patentamt / European Patent Office / Office européen des brevets**

(11) **EP 4 624 957 A1**

(12) # EUROPEAN PATENT APPLICATION
published in accordance with Art. 153(4) EPC

(43) Date of publication:
**01.10.2025 Bulletin 2025/40**

(21) Application number: **23910678.4**

(22) Date of filing: **27.12.2023**

(51) International Patent Classification (IPC):
*G01R 31/385* (2019.01)     *G01R 31/367* (2019.01)
*G06Q 10/04* (2023.01)     *G06N 3/08* (2023.01)
*H01M 10/48* (2006.01)

(52) Cooperative Patent Classification (CPC):
Y02E 60/10

(86) International application number:
**PCT/CN2023/142194**

(87) International publication number:
**WO 2024/140759 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2022 CN 202211688929**

(71) Applicant: **Huawei Technologies Co., Ltd.
Shenzhen, Guangdong 518129 (CN)**

(72) Inventors:
• **YE, Junjian
Shenzhen, Guangdong 518129 (CN)**
• **ZHENG, Jiale
Shenzhen, Guangdong 518129 (CN)**
• **ZHANG, Keli
Shenzhen, Guangdong 518129 (CN)**
• **PAN, Lujia
Shenzhen, Guangdong 518129 (CN)**
• **LI, Linfu
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **BATTERY PERFORMANCE PREDICTION METHOD, MODEL TRAINING METHOD, AND RELATED APPARATUSES**

(57)     A battery performance prediction method is provided, and is applied to the field of artificial intelligence technologies. In the method, the first network first predicts a parameter of a battery in a procedure of a second stage process based on a parameter of the battery in a procedure of a first stage process, and then fuses the parameter of the battery in the procedure of the first stage process with the parameter that is obtained through prediction and that is of the battery in the procedure of the second stage process, and a second network predicts a performance parameter of the battery based on a plurality of features of the battery, thereby effectively improving prediction accuracy of the performance parameter of the battery. In this solution, battery performance is predicted by fusing a first stage parameter of the battery with a second stage parameter that is obtained through prediction and that is of the battery. This can avoid performing the second stage process on the battery while ensuring prediction accuracy of the battery performance, thereby effectively improving efficiency of determining the battery performance and reducing costs for determining the battery performance.

FIG. 5

## Description

This application claims priority to Chinese Patent Application No. 202211688929.9, filed with the China National Intellectual Property Administration on December 27, 2022 and entitled "BATTERY PERFORMANCE PREDICTION METHOD, MODEL TRAINING METHOD, AND RELATED APPARATUS", which is incorporated herein by reference in its entirety.

## TECHNICAL FIELD

This application relates to the field of artificial intelligence technologies, and in particular, to a battery performance prediction method, a model training method, and a related apparatus.

## BACKGROUND

Affected by environmental factors, the power battery market and the battery energy storage market are increasingly large, resulting in an increase in a demand for batteries. Therefore, how to improve battery production efficiency and reduce battery production costs has become a focus of attention in the industry.

Currently, after batteries are manufactured, performance of the batteries usually needs to be evaluated by using various processes, to determine whether each battery is qualified. For example, due to factors such as a raw material and a manufacturing error, capacities of batteries manufactured in a same batch may also vary. Therefore, after the batteries are manufactured, a battery capacity grading process usually needs to be further performed on the batteries, to determine an actual capacity of each battery. The battery capacity grading process is an electrochemical process, and involves procedures such as discharging and charging on a battery. Therefore, efficiency is low, and costs are high.

Therefore, currently, a battery performance determining method with high efficiency and low costs is urgently needed.

## SUMMARY

This application provides a battery performance prediction method, to avoid performing a stage process on a battery, thereby effectively improving efficiency of determining battery performance, and reducing costs for determining the battery performance.

According to a first aspect of this application, a battery performance prediction method is provided, and is applied to the field of artificial intelligence technologies. The method includes: obtaining a first stage parameter of a battery whose capacity is to be predicted, where the first stage parameter includes a parameter of the battery in a procedure of undergoing a first stage process.

Then, the first stage parameter is processed by using a first network, to obtain a second stage result of the battery, where the second stage result is obtained based on a second stage parameter, and the second stage parameter is a parameter that is predicted by the first network and that is of the battery in a procedure of undergoing a second stage process. The first network may be, for example, an MLP, a transformer, or a residual network.

Finally, a performance parameter of the battery is obtained through prediction based on the first stage parameter and the second stage result by using a second network. The second network may be, for example, an MLP, a transformer, or a residual network. Simply speaking, the second network predicts the performance parameter of the battery based on the first stage parameter of the battery and the parameter that is predicted by the first network and that is of the battery in the procedure of undergoing the second stage process.

In this solution, the first network first predicts the parameter of the battery in the procedure of the second stage process based on the parameter of the battery in the procedure of the first stage process, and then fuses the parameter of the battery in the procedure of the first stage process with the parameter that is obtained through prediction and that is of the battery in the procedure of the first stage process, and the second network predicts the performance parameter of the battery based on a plurality of features of the battery, thereby effectively improving prediction accuracy of battery performance. In this solution, battery performance is predicted by fusing the first stage parameter of the battery with the second stage parameter that is obtained through prediction and that is of the battery. This can avoid performing the second stage process on the battery while ensuring prediction accuracy of the battery performance, thereby effectively improving efficiency of determining the battery performance and reducing costs for determining the battery performance.

In a possible implementation, the first stage process includes a battery production process. In this case, the first stage parameter is a parameter obtained in a procedure of performing the battery production process on the battery, and the first stage parameter includes parameters, for example, a formation voltage, a formation temperature, a quantity of electrolytes filled at a time, an open circuit voltage (that is, a potential difference between two electrodes when the battery is not discharged and is open-circuited), an open circuit resistance, a direct current internal resistance and a roll core weight under specific load and a discharge current, and the like of the battery. The second stage process includes a battery capacity grading process, and the performance parameter includes a battery capacity.

Alternatively, the first stage process includes a first test of an open circuit voltage (Open circuit voltage, OCV), the second stage process includes a second test of the OCV, and the performance parameter includes a battery self-discharge rate.

In a possible implementation, the second stage result is the second stage parameter obtained by the first network through prediction, and the second stage parameter is the parameter of the battery in the procedure of undergoing the second stage process. That is, an input of the second network is the first stage parameter of the battery and a second stage prediction parameter of the battery, and the second network predicts the battery performance based on the parameters in the two different stages.

In a possible implementation, that the performance parameter of the battery is obtained through prediction based on the first stage parameter and the second stage result by using a second network specifically includes: processing the first stage parameter by using a feature extraction layer in the second network, to obtain a first feature, where the first feature represents a feature of the first stage parameter; and performing fusion processing on the first feature and a second feature by using a feature fusion layer in the second network, to obtain the performance parameter of the battery through prediction, where the second feature is the second stage result output by a feature extraction layer in the first network, and the second feature represents a feature of the parameter of the battery in the procedure of undergoing the second stage process.

That is, the second feature output by the feature extraction layer of the first network is used as an input of the second network, so that the second network may perform fusion processing on the second feature and the first feature corresponding to the first stage parameter of the battery, and does not need to perform feature extraction on the second stage prediction parameter that is of the battery and that is obtained by the first network through prediction, thereby improving data processing efficiency of the second network.

In a possible implementation, the method further includes: performing feature extraction on the first stage parameter by using a third network, to obtain a first feature, where the first feature represents a feature of the first stage parameter; then, processing the first feature by using the first network, to obtain the second stage result, where the second stage result is a second feature output by a feature extraction layer in the first network, and the second feature represents a feature of the parameter of the battery in the procedure of undergoing the second stage process; and performing fusion processing on the first feature and the second feature by using the second network, to obtain the performance parameter of the battery through prediction.

In other words, the third network is responsible for extracting the first feature corresponding to the first stage parameter of the battery; the first network is responsible for obtaining, through prediction, the second stage parameter of the battery based on the first feature extracted by the third network, and outputting the second feature extracted by the feature extraction layer; and the second network is responsible for performing fusion processing on the first feature extracted by the third network and the second feature extracted by the first network, to obtain the performance parameter of the battery through prediction.

In a possible implementation, the first network is specifically configured to predict N target parameters of the battery in the procedure of undergoing the second stage process, where the battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In this solution, some parameters that have a large degree of contribution to the prediction of battery performance are selected from a plurality of second stage parameters of the battery, so that prediction of highdimensional data based on low-dimensional data can be avoided, and prediction accuracy of the first network can be improved, thereby improving prediction accuracy of the battery performance.

In a possible implementation, the method further includes: obtaining a regression model, where the regression model represents a relationship between a battery capacity, and the parameter of the battery in the procedure of undergoing the first stage process and the parameter of the battery in the procedure of undergoing the second stage process, that is, the regression model may be used to predict the performance parameter of the battery based on the parameter of the battery in the procedure of the first stage process and the parameter of the battery in the procedure of the second stage process; then, obtaining, based on the regression model, a degree of contribution of each of the M parameters to the prediction of the performance parameter of the battery; and determining the N target parameters from the M parameters based on the degree of contribution of each parameter to the prediction of the performance parameter of the battery.

In a possible implementation, the regression model is a linear mathematical model or a neural network model.

According to a second aspect of this application, a model training method is provided, including: obtaining a training data set, where the training data set includes a first stage parameter, a second stage parameter, and a performance parameter that are of a same battery, the first stage parameter includes a parameter of the battery in a procedure of undergoing a first stage process, and the second stage parameter includes a parameter of the battery in a procedure of undergoing a second stage process; processing the first stage parameter by using a first network, to obtain a second stage prediction parameter of the battery, where the second stage parameter is a parameter that is obtained by the first network through prediction and that is of the battery in the procedure of undergoing the second stage process; obtaining a performance prediction parameter of the battery by using a second network based on the first stage parameter and an output result of the first network, where the output result of the first network is obtained based on the second stage prediction parameter; and updating the first network and the second network based on a first loss function and a second loss function, where the first loss function represents a difference between the second stage parameter and the second stage prediction parameter, and the second loss function represents a difference between the performance parameter of the battery and the performance prediction parameter.

In this solution, the first network obtains, through prediction, the second stage parameter of the battery based on the first stage parameter of the battery under supervision of an actual second stage parameter of the battery, and the second network predicts the performance parameter of the battery with reference to the first stage parameter of the battery and the second stage parameter that is obtained by the first network through prediction and that is of the battery. Because the first network is obtained through training under supervision of the actual second stage parameter of the battery, accuracy of the second stage parameter that is of the battery and that is predicted by the first network can be effectively ensured. In addition, the second network predicts the performance parameter of the battery by fusing parameters of the battery in the first stage process and the second stage process, so that prediction accuracy of the performance parameter of the battery can be effectively ensured. Moreover, a network model finally obtained through training does not depend on the second stage parameter of the battery when predicting performance of the battery, thereby omitting a procedure of performing the second stage process on the battery.

In a possible implementation, the first stage process includes a battery production process. In this case, the first stage parameter is a parameter obtained in a procedure of performing the battery production process on the battery, and the first stage parameter includes parameters, for example, a formation voltage, a formation temperature, a quantity of electrolytes filled at a time, an open circuit voltage (that is, a potential difference between two electrodes when the battery is not discharged and is open-circuited), an open circuit resistance, a direct current internal resistance and a roll core weight under specific load and a discharge current, and the like of the battery. The second stage process includes a battery capacity grading process, and the performance parameter includes a battery capacity.

Alternatively, the first stage process includes a first test of an OCV, the second stage process includes a second test of the OCV, and the performance parameter includes a battery self-discharge rate.

In a possible implementation, the output result of the first network is the second stage prediction parameter obtained by the first network through prediction.

In a possible implementation, the obtaining a performance prediction parameter of the battery by using a second network based on the first stage parameter and an output result of the first network includes: processing the first stage parameter by using a feature extraction layer in the second network, to obtain a first feature, where the first feature represents a feature of the first stage parameter; and performing fusion processing on the first feature and a second feature by using a feature fusion layer in the second network, to obtain the performance prediction parameter of the battery through prediction, where the second feature is an output result of a feature extraction layer in the first network, and the second feature represents a feature of the parameter of the battery in the procedure of undergoing the second stage process.

In a possible implementation, the method further includes: extracting a third feature corresponding to the second stage parameter of the battery; and updating the first network based on a third loss function, where the third loss function represents a difference between the second feature and the third feature.

In this solution, the third loss function is constructed to represent a difference between a feature extracted by the first network and an actual feature of the second stage parameter of the battery, and the first network is trained based on the third loss function, so that the feature extracted by the first network can be as close as possible to the feature of the second stage parameter, to ensure accuracy of subsequently predicting the performance parameter of the battery by the second network based on an output of the first network.

In a possible implementation, the method further includes: performing feature extraction on the first stage parameter by using a third network, to obtain a first feature, where the first feature represents a feature of the first stage parameter; the processing the first stage parameter by using a first network includes: processing the first feature by using the first network, to obtain a second feature output by a feature extraction layer in the first network, where the second feature represents a feature of the parameter of the battery in the procedure of undergoing the second stage process; and the obtaining a performance prediction parameter of the battery by using a second network based on the first stage parameter and an output result of the first network includes: performing fusion processing on the first feature and the second feature by using the second network, to obtain the performance prediction parameter of the battery through prediction.

In a possible implementation, the first network is specifically configured to predict N target parameters of the battery in the procedure of undergoing the second stage process, where the battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In a possible implementation, the method further includes: obtaining a regression model, where the regression model represents a relationship between the performance parameter of the battery, and the parameter of the battery in the procedure of the first stage process and the parameter of the battery in the procedure of the second stage process; obtaining, based on the regression model, a degree of contribution of each of the M parameters to the prediction of the performance parameter of the battery; and determining the N target parameters from the M parameters based on the degree of contribution of each parameter to the prediction of the performance parameter of the battery.

In a possible implementation, the regression model is a linear mathematical model or a neural network model.

According to a third aspect of this application, a battery performance prediction apparatus is provided, and includes an obtaining module, configured to obtain a first stage parameter of a battery, where the first stage parameter includes a parameter of the battery in a procedure of undergoing a first stage process; and

a processing module, configured to process the first stage parameter by using a first network, to obtain a second stage result of the battery, where the second stage result is obtained based on a second stage parameter, the second stage parameter is a parameter that is predicted by the first network and that is of the battery in a procedure of undergoing a second stage process, and the second stage process is performed after the first stage process.

The processing module is further configured to obtain, through prediction, a performance parameter of the battery based on the first stage parameter and the second stage result by using a second network.

In a possible implementation, the first stage process includes a battery production process, the second stage process includes a battery capacity grading process, and the performance parameter includes a battery capacity.

Alternatively, the first stage process includes a first test of an OCV, the second stage process includes a second test of the OCV, and the performance parameter includes a battery self-discharge rate.

In a possible implementation, the second stage result is the second stage parameter obtained by the first network through prediction, and the second stage parameter is the parameter of the battery in the procedure of undergoing the second stage process.

In a possible implementation, the processing module is further configured to:

process the first stage parameter by using a feature extraction layer in the second network, to obtain a first feature; and
perform fusion processing on the first feature and a second feature by using a feature fusion layer in the second network, to obtain the performance parameter of the battery through prediction.

The second feature is the second stage result output by a feature extraction layer in the first network.

In a possible implementation, the processing module is further configured to:

perform feature extraction on the first stage parameter by using a third network, to obtain a first feature;
process the first feature by using the first network, to obtain the second stage result, where the second stage result is a second feature output by a feature extraction layer in the first network; and
perform fusion processing on the first feature and the second feature by using the second network, to obtain the performance parameter of the battery through prediction.

In a possible implementation, the first network is specifically configured to predict N target parameters of the battery in the procedure of undergoing the second stage process.

The battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In a possible implementation, the obtaining module is further configured to obtain a regression model, where the regression model represents a relationship between the performance parameter of the battery, and the parameter of the battery in the procedure of undergoing the first stage process and the parameter of the battery in the procedure of undergoing the second stage process.

The processing module is further configured to obtain, based on the regression model, a degree of contribution of each of the M parameters to the prediction of the performance parameter of the battery.

The processing module is further configured to determine the N target parameters from the M parameters based on the degree of contribution of each parameter to the prediction of the performance parameter of the battery.

According to a fourth aspect of this application, a model training apparatus is provided, and includes:

an obtaining module, configured to obtain a training data set, where the training data set includes a first stage parameter, a second stage parameter, and a performance parameter that are of a same battery, the first stage parameter includes a parameter of the battery in a procedure of undergoing a first stage process, and the second stage parameter includes a parameter of the battery in a procedure of undergoing a second stage process;

a processing module, configured to process the first stage parameter by using a first network, to obtain a second stage prediction parameter of the battery, where the second stage parameter is a parameter that is obtained by the first network through prediction and that is of the battery in the procedure of undergoing the second stage process, where the processing module is further configured to obtain a performance prediction parameter of the battery by using a second network based on the first stage parameter and an output result of the first network, where the output result of the first network is obtained based on the second stage prediction parameter; and

an updating module, configured to update the first network and the second network based on a first loss function and a second loss function.

The first loss function represents a difference between the second stage parameter and the second stage prediction parameter, and the second loss function represents a difference between the performance parameter of the battery and the performance prediction parameter.

In a possible implementation, the first stage process includes a battery production process, and the second stage process includes a battery capacity grading process.

Alternatively, the first stage process includes a first test of an open circuit voltage OCV, and the second stage process includes a second test of the OCV.

In a possible implementation, the output result of the first network is the second stage prediction parameter obtained by the first network through prediction.

In a possible implementation, the processing module is further configured to:

process the first stage parameter by using a feature extraction layer in the second network, to obtain a first feature; and

perform fusion processing on the first feature and a second feature by using a feature fusion layer in the second network, to obtain the performance prediction parameter of the battery.

The second feature is an output result of a feature extraction layer in the first network.

In a possible implementation, the processing module is further configured to extract a third feature corresponding to the second stage parameter of the battery.

The updating module is further configured to update the first network based on a third loss function, where the third loss function represents a difference between the second feature and the third feature.

In a possible implementation, the processing module is further configured to:

perform feature extraction on the first stage parameter by using a third network, to obtain a first feature, where the first feature represents a feature of the first stage parameter;

process the first feature by using the first network, to obtain a second feature output by a feature extraction layer in the first network; and

perform fusion processing on the first feature and the second feature by using the second network, to obtain the performance prediction parameter of the battery.

In a possible implementation, the first network is specifically configured to predict N target parameters of the battery in the procedure of undergoing the second stage process.

The battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In a possible implementation, the obtaining module is further configured to obtain a regression model, where the regression model represents a relationship between the performance parameter of the battery, and the parameter of the battery in the procedure of undergoing the first stage process and the parameter of the battery in the procedure of undergoing the second stage process.

The processing module is further configured to obtain, based on the regression model, a degree of contribution of each of the M parameters to the prediction of the performance parameter of the battery.

The processing module is further configured to determine the N target parameters from the M parameters based on the degree of contribution of each parameter to the prediction of the performance parameter of the battery.

According to a fifth aspect of this application, a battery performance prediction apparatus is provided, and may include a processor. The processor is coupled to a memory, the memory stores program instructions, and when the program instructions stored in the memory are executed by the processor, the method according to any one of the first aspect or the implementations of the first aspect is implemented. For details of steps that are performed by the processor and that are in the possible implementations of the first aspect, refer to the first aspect. Details are not described herein again.

According to a sixth aspect of this application, a model training apparatus is provided, and may include a processor. The processor is coupled to a memory, the memory stores program instructions, and when the program instructions stored in the memory are executed by the processor, the method according to any one of the second aspect or the implementations of the second aspect is implemented. For steps that are performed by the processor and that are in the possible implementations of the second aspect, refer to the second aspect. Details are not described herein again.

According to a seventh aspect of this application, a computer-readable storage medium is provided. The computer-readable storage medium stores a computer program, and when the computer program is run on a computer, the computer is enabled to perform the method according to any one of the implementations of the first aspect.

According to an eighth aspect of this application, a circuit system is provided. The circuit system includes a processing circuit, and the processing circuit is configured to perform the method according to any one of the implementations of the first aspect.

According to a ninth aspect of this application, a computer program product is provided. When the computer program product runs on a computer, the computer is enabled to perform the method according to any one of the implementations of the first aspect.

According to a tenth aspect of this application, a chip system is provided. The chip system includes a processor that is configured to support a server or a threshold obtaining apparatus in implementing functions in any one of the implementations of the first aspect, for example, sending or processing data and/or information in the foregoing method. In a possible design, the chip system further includes a memory, and the memory is configured to store program instructions and data that are necessary for the server or a communication device. The chip system may include a chip, or may include a chip and another discrete component.

For beneficial effects of the second aspect to the eleventh aspect, refer to descriptions of the first aspect. Details are not described herein again.

## BRIEF DESCRIPTION OF DRAWINGS

FIG. 1 is a diagram of a structure of a convolutional neural network according to an embodiment of this application;
FIG. 2 is a diagram of a structure of another convolutional neural network according to an embodiment of this application;
FIG. 3 is a diagram of a structure of an electronic device 101 according to an embodiment of this application.
FIG. 4 is a schematic flowchart of a model training method according to an embodiment of this application;
FIG. 5 is a schematic flowchart of a battery performance prediction method according to an embodiment of this application;
FIG. 6 is a diagram of a model training phase according to an embodiment of this application;
FIG. 7 is a diagram of a model inference phase according to an embodiment of this application;
FIG. 8 is a diagram of another model training phase according to an embodiment of this application;
FIG. 9 is a diagram of another model training phase according to an embodiment of this application;
FIG. 10 is a diagram of another model inference phase according to an embodiment of this application;
FIG. 11 is a diagram of another model training phase according to an embodiment of this application;
FIG. 12 is a diagram of another model inference phase according to an embodiment of this application;
FIG. 13 is a schematic flowchart of screening out a capacity grading stage parameter according to an embodiment of this application;
FIG. 14 is a diagram of a structure of a battery performance prediction apparatus according to an embodiment of this application;
FIG. 15 is a diagram of a structure of a model training apparatus according to an embodiment of this application;
FIG. 16 is a diagram of a structure of an execution device according to an embodiment of this application;
FIG. 17 is a diagram of a structure of a chip according to an embodiment of this application; and
FIG. 18 is a diagram of a structure of a computer-readable storage medium according to an embodiment of this application.

## DESCRIPTION OF EMBODIMENTS

To make the objectives, technical solutions, and advantages of this application clearer and more comprehensible, the following describes embodiments of this application with reference to accompanying drawings. It is clear that the described embodiments are merely a part of but not all of embodiments of this application. A person of ordinary skill in the art may learn that, as a new application scenario emerges, the technical solutions provided in embodiments of this application are also applicable to a similar technical problem.

In the specification, claims, and accompanying drawings of this application, terms "first", "second", and the like are intended to distinguish between similar objects but do not necessarily indicate a specific order or sequence. It should be understood that descriptions termed in such a manner are interchangeable in proper cases, so that embodiments can be implemented in another order than the order illustrated or described in this application. Moreover, terms "include", "have" and any other variants are intended to cover non-exclusive inclusion, for example, a procedure, method, system, product, or device that includes a list of steps or modules is not necessarily limited to those listed steps or modules, but may include other steps or modules that are not expressly listed or inherent to such a procedure, method, product, or device. Names or numbers of steps in this application do not mean that the steps in the method procedure need to be performed in a time/logical sequence indicated by the names or numbers. An execution sequence of the steps in the procedure that have been named or numbered can be changed based on a technical objective to be achieved, provided that same or similar technical effect can be achieved. Division into the units in this application is logical division and may be other division during actual implementation. For example, a plurality of units may be combined or integrated into another system, or some features may be ignored or not performed. In addition, the displayed or discussed mutual couplings or direct couplings or communication connections may be implemented through some interfaces. The indirect couplings or communication connections between the units may be implemented in electronic or other similar forms. This is not limited in this application. In addition, units or subunits described as separate parts may or may not be physically separate, may or may not be physical units, or may be distributed into a plurality of circuit units. Some or all of the units may be selected according to actual requirements to achieve the objectives of the solutions of this application.

For ease of understanding, the following first describes some technical terms used in embodiments of this application.

(1) Battery capacity grading

After batteries are manufactured in a production workshop, capacities of the batteries vary. Generally, a capacity test needs to be performed to analyze the capacities of the batteries. This procedure is referred to as battery capacity grading, namely, battery capacity sorting. Simply speaking, after a batch of batteries are manufactured, although sizes and specifications of the batteries are the same, capacities of the batteries usually vary. Therefore, the capacities of the batteries are usually tested by using a battery capacity grading process. A procedure of testing a battery capacity includes: fully charging a battery according to a guideline, and then discharging the battery according to the guideline. The battery capacity is obtained by multiplying time used for discharging the battery by a discharging current. Generally, a battery is qualified only when a tested capacity of the battery meets or is greater than a designed capacity, and a battery whose tested capacity is less than the designed capacity cannot be considered as a qualified battery.

(2) Neural network

The neural network may include a neural unit. The neural unit may be an operation unit that uses xs (namely, input data) and an intercept of 1 as inputs, and an output of the operation unit may be as follows:

$$h_{W,b}(x) = f(W^T x) = f(\sum_{s=1}^{n} W_s x_s + b)$$

s=1, 2, ..., and n, n is a natural number greater than 1, Ws is a weight of xs, b is a bias of the neural unit, and f is an activation function (activation function) of the neural unit, and is used to introduce a non-linear characteristic into the neural network, to convert an input signal in the neural unit into an output signal. The output signal of the activation function may be used as an input of a next convolutional layer, and the activation function may be a sigmoid function. The neural network is a network formed by linking a plurality of single neural units together. To be specific, an output of a neural unit may be an input of another neural unit. An input of each neural unit may be connected to a local receptive field of a previous layer, to extract a feature of the local receptive field. The local receptive field may be a region including several neural units.

(3) Deep neural network

The deep neural network (Deep Neural Network, DNN), also referred to as a multi-layer neural network, may be understood as a neural network having many hidden layers. "Many" herein does not have a special measurement standard. The DNN is classified based on locations of different layers, and a neural network in the DNN may be classified into three layers: an input layer, a hidden layer, and an output layer. Generally, the first layer is the input layer, the last layer is the output layer, and the middle layer is the hidden layer. Layers are fully connected to each other. To be specific, any neuron at an $i^{th}$ layer is necessarily connected to any neuron at an $(i+1)^{th}$ layer. Although the DNN seems complex, functioning at each layer is not complicated. Simply speaking, the DNN is the following linear relationship expression: $\vec{y} = \alpha (W\vec{x} + \vec{b})$, where $\vec{x}$ is an input vector, $\vec{y}$ is an output vector, $\vec{b}$ is an offset vector, W is a weight matrix (also referred to as a coefficient), and $\alpha()$ is an activation function. At each layer, only such a simple operation is performed on the input vector $\vec{x}$ to obtain the output vector $\vec{y}$. Because the DNN includes a large quantity of layers, there are a large quantity of coefficients W and a large quantity of offset vectors $\vec{b}$. Definitions of these parameters in the DNN are as follows: The coefficient W is used as an example. It is assumed that in a three-layer DNN, a linear coefficient from a $4^{th}$ neuron at a second layer to a $2^{nd}$ neuron at a third layer is defined as $w_{24}^{3}$. The superscript 3 represents a layer at which the coefficient W is located, and the subscript corresponds to an output index 2 of the third layer and an input index 4 of the second layer. In conclusion, a coefficient from a $k^{th}$ neuron at an $(L-1)^{th}$ layer to a $j^{th}$ neuron at an $L^{th}$ layer is defined as $W_{jk}^{L}$. It should be noted that the input layer does not have the parameter W. In the deep neural network, more hidden layers make the network more capable of describing a complex case in the real world. Theoretically, a model with more parameters has higher complexity and a larger "capacity", and indicates that the model can complete a more complex learning task. Training the deep neural network is a procedure of learning a weight matrix, and a final objective of the training is to obtain a weight matrix of all layers of the trained deep neural network (a weight matrix formed by vectors W at many layers).

(4) Convolutional neural network (Convolutional Neural Network, CNN)

The convolutional neural network is a deep neural network with a convolutional structure. The convolutional neural network includes a feature extractor including a convolutional layer and a sub-sampling layer. The feature extractor may be considered as a filter. A convolution procedure may be considered as performing convolution by using a trainable filter and an input image or a feature map (feature map). The convolutional layer is a neuron layer that performs convolution processing on an input signal and that is in the convolutional neural network (for example, a first convolutional layer and a second convolutional layer in embodiments). At the convolutional layer of the convolutional neural network, one neuron may be connected only to some adjacent-layer neurons. One convolutional layer usually includes several feature planes, and each feature plane may include some neural units that are in a rectangular arrangement. Neural units in a same feature plane share a weight, and the shared weight herein is a convolution kernel. Weight sharing may be understood as that an image information extraction manner is irrelevant to a location. A principle implied herein is that statistical information of a part of an image is the same as that of other parts. This means that image information learned in a part can also be used in other parts. Therefore, for all locations on the image, image information can be obtained through same learning. At a same convolutional layer, a plurality of convolution kernels may be used to extract different image information. Usually, a larger quantity of convolution kernels indicates richer image information reflected in a convolution operation.

The convolution kernel may be initialized in a form of a random-size matrix. In a procedure of training the convolutional neural network, the convolution kernel may obtain an appropriate weight through learning. In addition, benefits directly brought by weight sharing are reduction of connections between layers of the convolutional neural network and reduction of overfitting risk.

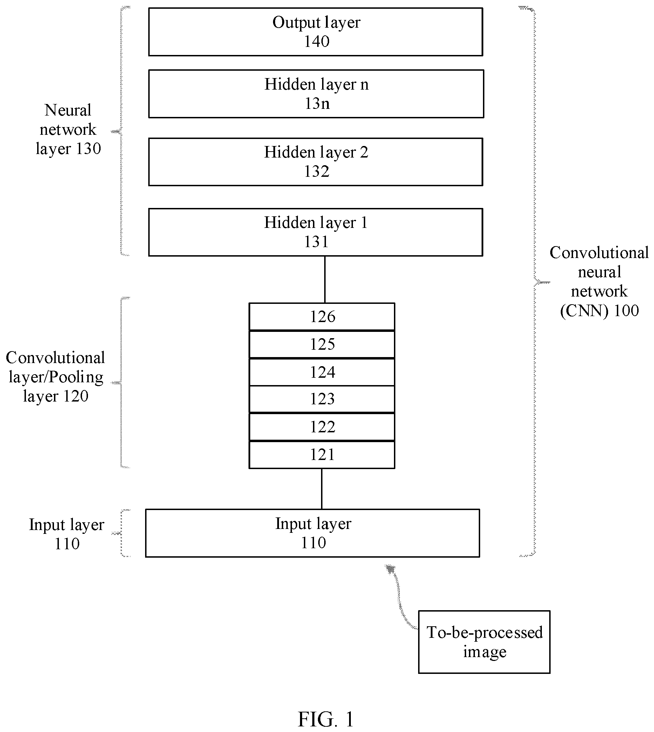

Specifically, as shown in FIG. 1, a convolutional neural network (CNN) 100 may include an input layer 110, a convolutional layer/pooling layer 120, and a neural network layer 130, and the pooling layer is optional.

A structure including the convolutional layer/pooling layer 120 and the neural network layer 130 may be a first convolutional layer and a second convolutional layer described in this application, the input layer 110 is connected to the convolutional layer/pooling layer 120, the convolutional layer/pooling layer 120 is connected to the neural network layer 130, an output of the neural network layer 130 may be input into an activation layer, and the activation layer may perform non-linearization processing on the output of the neural network layer 130.

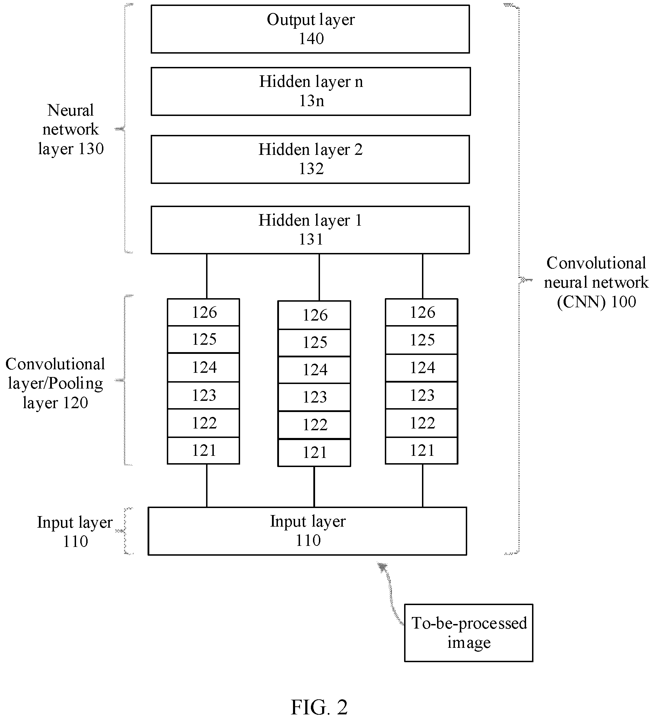

Convolutional layer/pooling layer 120: Convolutional layer: As shown in FIG. 2, the convolutional layer/pooling layer 120 may include layers 121 to 126. In an implementation, the layer 121 is a convolutional layer, a layer 122 is a pooling layer, a layer 123 is a convolutional layer, a layer 124 is a pooling layer, a layer 125 is a convolutional layer, and the layer 126 is a pooling layer. In another implementation, layers 121 and 122 are convolutional layers, the layer 123 is a pooling layer, layers 124 and 125 are convolutional layers, and the layer 126 is a pooling layer. That is, an output of a convolutional layer may be used as an input of a subsequent pooling layer, or may be used as an input of another convolutional layer to continue a convolution operation.

The convolutional layer 121 is used as an example. The convolutional layer 121 may include a plurality of convolution operators. A convolution operator is also referred to as a kernel. In image processing, the convolution operator functions as a filter that extracts specific information from an input image matrix. The convolution operator may be essentially a weight matrix, and the weight matrix is usually predefined. In a procedure of performing a convolution operation on an image, the weight matrix is usually used to process pixels at a granularity level of one pixel (or two pixels, which depends on a value of a stride (stride)) in a horizontal direction on an input image, to extract a specific feature from the image. A size of the weight matrix should be related to a size of the image. It should be noted that a depth dimension (depth dimension) of the weight matrix is the same as a depth dimension of the input image. During a convolution operation, the weight matrix extends to an entire depth of the input image. Therefore, a convolutional output of a single depth dimension is generated by performing convolution with a single weight matrix. However, in most cases, a plurality of weight matrices of a same dimension rather than a single weight matrix are used. Outputs of the weight matrices are stacked to form a depth dimension of a convolutional image. Different weight matrices may be used to extract different features of the image. For example, one weight matrix is used to extract edge information of the image, another weight matrix is used to extract a specific color of the image, still another weight matrix is used to blur an unnecessary noise in the image, and so on. Because the plurality of weight matrices have a same dimension, feature maps extracted by using the plurality of weight matrices with the same dimension also have a same dimension. Then, the plurality of extracted feature maps with the same dimension are fused to form an output of the convolution operation.

Weight values in these weight matrices need to be obtained in actual application through massive training. The weight matrices that are formed based on the weight values obtained through training may be used to extract information from the input image, to help the convolutional neural network 100 perform correct prediction.

When the convolutional neural network 100 includes a plurality of convolutional layers, a large quantity of general features are usually extracted at an initial convolutional layer (for example, the convolutional layer 121). The general feature may be also referred to as a low-level feature. As a depth of the convolutional neural network 100 increases, a feature extracted at a more subsequent convolutional layer (for example, the convolutional layer 126) is more complex, for example, a high-level semantic feature. A feature with higher semantics is more applicable to a tobe-resolved problem.

Pooling layer: Because a quantity of training parameters usually needs to be reduced, a pooling layer usually needs to be periodically introduced after a convolutional layer, that is, the layers 121 to 126 shown in 120 in FIG. 1. One convolutional layer may be followed by one pooling layer, or a plurality of convolutional layers may be followed by one or more pooling layers.

Neural network layer 130: After processing performed by the convolutional layer/pooling layer 120, the convolutional neural network 100 still cannot output required output information. This is because as described above, the convolutional layer/pooling layer 120 only extracts a feature and reduces a parameter brought by the input image. However, to generate final output information (required class information or other related information), the convolutional neural network 100 needs to use the neural network layer 130 to generate an output of one required class or outputs of a group of required classes. Therefore, the neural network layer 130 may include a plurality of hidden layers (131, 132, ..., and 13n shown in FIG. 1) and an output layer 140. Parameters included in the plurality of hidden layers may be obtained by performing pre-training based on related training data of a specific task type, for example, the task type may include image recognition, image classification, and super-resolution image reconstruction.

The plurality of hidden layers in the neural network layer 130 are followed by the output layer 140, namely, the last layer of the entire convolutional neural network 100. The output layer 140 has a loss function similar to classification cross entropy, and the loss function is specifically used to calculate a prediction error. Once forward propagation of the entire convolutional neural network 100 (for example, propagation from layers 110 to 140 in FIG. 2 is forward propagation) is completed, back propagation (for example, propagation from layers 140 to 110 in FIG. 2 is back propagation) is started to update weight values and deviations of the layers mentioned above, to reduce a loss of the convolutional neural network 100 and an error between an ideal result and a result output by the convolutional neural network 100 through the output layer.

It should be noted that the convolutional neural network 100 shown in FIG. 1 is merely used as an example of a convolutional neural network. In specific application, the convolutional neural network may alternatively exist in a form of another network model. For example, the plurality of convolutional layers/pooling layers shown in FIG. 2 are parallel, and features extracted by the convolutional layers/pooling layers are separately input into the entire neural network layer 130 for processing.

(5) Multi-layer perception (Multi-Layer Perception, MLP)

The MLP is a feedforward artificial neural network model, and is used to map a plurality of input data sets to a single output data set. Generally, the MLP includes three neural network layers: an input layer, a hidden layer, and an output layer. There may be one or more hidden layers, different neural network layers in the MLP are fully connected to each other, and any neuron at an upper layer is connected to all neurons at a lower layer.

(6) Attention network

The attention network is a network model that uses an attention mechanism to improve a model training speed. Currently, a typical attention network includes a transformer model. The model to which the attention mechanism is applied can assign different weights to parts of an input sequence, so that more important feature information is extracted from the input sequence, and the model finally obtains a more accurate output.

In deep learning, the attention mechanism may be implemented by using a weight vector that describes importance. When an element is predicted or inferred, an association between the element and another element is determined based on the weight vector. For example, for a pixel in an image or a word in a sentence, a correlation between a target element and another element may be quantitatively estimated based on an attention vector, and a weighted sum of the attention vector is used as an approximate value of a target value.

An attention mechanism in deep learning simulates an attention mechanism of a human brain. For example, when a man views a picture, although the human eyes can see the whole picture, when the man observes the picture in depth, the eyes focus only on a part of the picture, and at this time, the human brain focuses on this small pattern. In other words, when the man observes an image carefully, attention of the human brain to the entire image is not balanced, and is distinguished by a specific weight. This is a core idea of the attention mechanism.

Simply speaking, a human visual processing system usually selectively focuses on some parts of an image and ignores other irrelevant information, thereby facilitating perception of the human brain. Similarly, in the attention mechanism of deep learning, some parts of an input may be more relevant than others in some issues involving language, speech, or vision. Therefore, the attention mechanism in the attention model can enable the attention model to perform different processing on different parts of input data, so that the attention model dynamically focuses only on data related to a task.

(7) Residual network (Residual Network, ResNet)

The residual network is an improved convolutional neural network, is characterized by easy optimization, and can improve accuracy by increasing a considerable depth. A residual block inside the residual network uses a skip connection. This alleviates a gradient disappearance problem caused by a depth increase in a deep neural network.

(8) Loss function

In a procedure of training a neural network, it is expected that an output of the neural network is as close as possible to a value that is actually expected to be predicted. Therefore, a current predicted value of the network may be compared with a target value that is actually expected, and then a weight vector of each layer of the neural network is updated based on a difference between the current predicted value and the target value (certainly, an initialization procedure is usually performed before a first update, that is, a parameter is preconfigured for each layer of the neural network). For example, if the predicted value of the network is high, the weight vector is adjusted to lower the predicted value, and adjustment is continuously performed until the neural network can predict the target value that is actually expected or a value that is very approximate to the target value that is actually expected. Therefore, "how to obtain, through comparison, a difference between the predicted value and the target value" needs to be predefined. This is the loss function (loss function) or an objective function (objective function). The loss function and the objective function are important equations that are used to measure the difference between the predicted value and the target value. The loss function is used as an example. A higher output value (loss) of the loss function indicates a larger difference. Therefore, training of the neural network is a procedure of minimizing the loss as much as possible.

(9) Back propagation algorithm

A neural network may use an error back propagation (back propagation, BP) algorithm to correct a value of a parameter in an initial model in a training procedure, so that an error loss of the model becomes increasingly small. Specifically, an input signal is transferred forward until an error loss occurs in an output, and the parameter in the initial model is updated by back propagating error loss information, so that the error loss converges. The back propagation algorithm is an error-loss-centered back propagation motion, and is intended to obtain an optimal model parameter, for example, a weight matrix.

(10) State of charge (state of charge, SOC)

The state of charge is a ratio of a remaining capacity of a battery that is used for a period of time or is not used for a long time to a capacity of the battery that is in a fully charged state, and is usually represented by a percentage.

Currently, after batteries are manufactured, performance of the batteries usually needs to be evaluated by using various processes, to determine whether each battery is qualified. For example, due to factors such as a raw material and a manufacturing error, capacities of batteries manufactured in a same batch may also vary. Therefore, after the batteries are manufactured, a battery capacity grading process usually further needs to be performed on the batteries, to determine an actual capacity of each battery, so that a manufacturer determines whether each battery is a qualified product. The battery capacity grading process is an electrochemical process, and usually requires procedures such as discharging and charging of a battery. Therefore, the battery capacity grading process needs to consume a large amount of time and a large quantity of power resources, has low efficiency, and has high costs.

In view of this, embodiments of this application provide a battery performance prediction method. First, a first network predicts a parameter of a battery in a procedure of a second stage process based on a parameter of the battery in a procedure of a first stage process, and then fuses the parameter of the battery in the procedure of the first stage process with the parameter that is obtained through prediction and that is of the battery in the procedure of the second stage process, and a second network predicts battery performance, thereby effectively improving prediction accuracy of the battery performance. This solution can avoid performing the second stage process on the battery while ensuring prediction accuracy of the battery performance, thereby effectively improving efficiency of determining the battery performance and reducing costs for determining the battery performance.

The battery performance prediction method provided in embodiments of this application may be applied to an electronic device. For example, the electronic device may be a device such as a server, a wireless electronic device in industrial control, a smartphone (mobile phone), a personal computer (personal computer, PC), a notebook computer, or a tablet computer. For ease of understanding, the following describes the method by using an example in which the method provided in embodiments of this application is applied to a server.

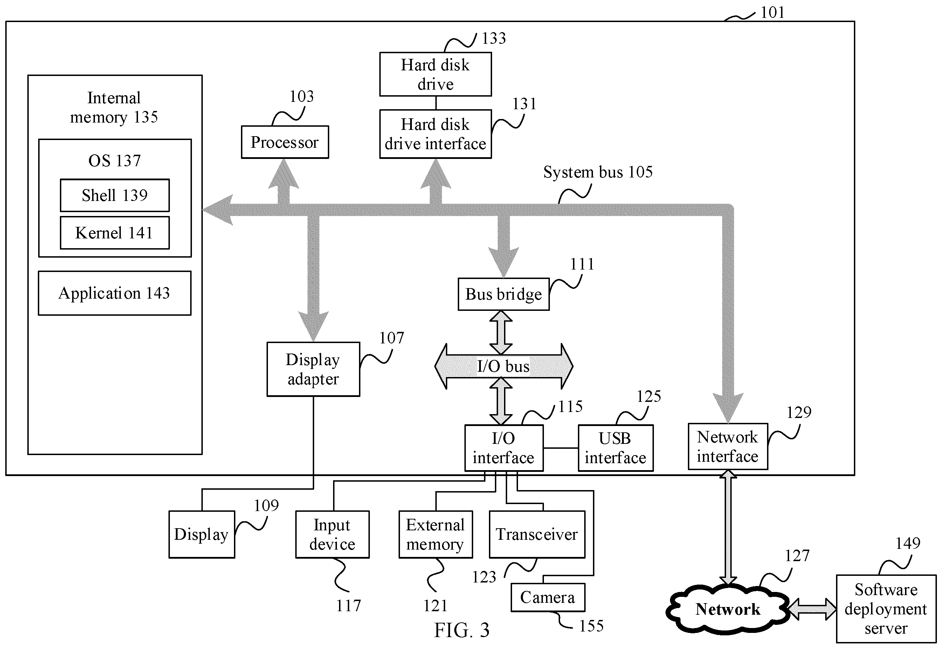

FIG. 3 is a diagram of a structure of an electronic device 101 according to an embodiment of this application. As shown in FIG. 3, the electronic device 101 includes a processor 103, and the processor 103 is coupled to a system bus 105. The processor 103 may be one or more processors, and each processor may include one or more processor cores. A display adapter (video adapter) 107 may drive a display 109, and the display 109 is coupled to the system bus 105. The system bus 105 is coupled to an input/output (I/O) bus through a bus bridge 111. An I/O interface 115 is coupled to the I/O bus. The I/O interface 115 communicates with a plurality of I/O devices, such as an input device 117 (for example, a touchscreen), an external memory 121 (for example, a hard disk, a floppy disk, an optical disc, or a USB disk), a multimedia interface, a transceiver 123 (which may send and/or receive a radio communication signal), a camera 155 (which may capture static and dynamic digital video images), and an external USB interface 125. Optionally, an interface connected to the I/O interface 115 may be a USB interface.

The processor 103 may be any conventional processor, including a reduced instruction set computing (reduced instruction set computing, RISC) processor, a complex instruction set computing (complex instruction set computing, CISC) processor, or a combination thereof. Optionally, the processor may be a dedicated apparatus such as an ASIC.

The electronic device 101 may communicate with a software deployment server 149 through a network interface 129. For example, the network interface 129 is a hardware network interface, for example, a network interface card. A network 127 may be an external network such as the internet, or may be an internal network such as the Ethernet or a virtual private network (virtual private network, VPN). Optionally, the network 127 may alternatively be a wireless network, for example, a Wi-Fi network, a cellular network, or the like.

A hard disk drive interface 131 is coupled to the system bus 105. A hardware drive interface is connected to the hard disk drive 133. An internal memory 135 is coupled to the system bus 105. Data running in the internal memory 135 may include an operating system (OS) 137, an application 143, and a scheduling table that are of the electronic device 101.

The operating system includes a shell 139 and a kernel (kernel) 141. The shell 139 is an interface between a user and the kernel of the operating system. The shell is an outermost layer of the operating system. The shell manages interaction between the user and the operating system: waiting for an input of the user, interpreting the input of the user to the operating system, and processing various output results of the operating system.

The kernel 141 includes those parts that are of the operating system and that are used for managing a memory, a file, a peripheral, and a system resource. The kernel 141 directly interacts with hardware, and the kernel of the operating system usually runs a process, provides inter-process communication, and provides functions such as CPU time slice management, interrupt, memory management, and I/O management.

For example, when the electronic device 101 is a smartphone, the application 143 includes a program related to instant messaging. In an embodiment, when the application 143 needs to be executed, the electronic device 101 may download the application 143 from the software deployment server 149.

Specifically, in the battery performance prediction method provided in embodiments of this application, the battery performance is predicted by using a trained neural network. For ease of understanding, the following first describes a model training method provided in embodiments of this application. The model training method is used to obtain, through training, a neural network used to predict the battery performance.

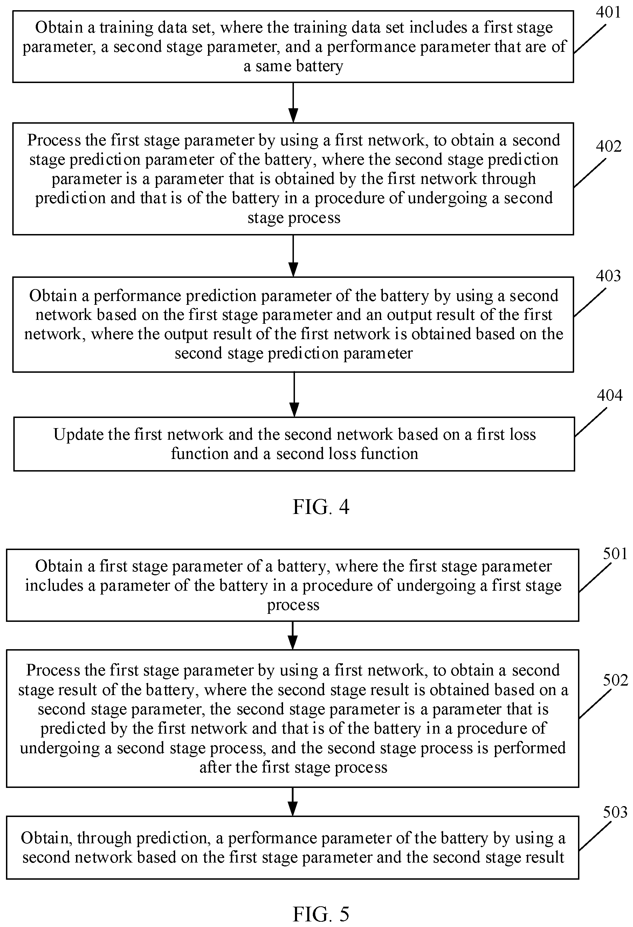

FIG. 4 is a schematic flowchart of a model training method according to an embodiment of this application. As shown in FIG. 4, an execution procedure of the model training method includes the following steps 401 to 404.

Step 401: Obtain a training data set, where the training data set includes a first stage parameter, a second stage parameter, and a performance parameter that are of a same battery.

In this embodiment, the training data set may include a plurality of groups of training data, and each group of training data includes the first stage parameter, the second stage parameter, and the performance parameter that are of the same battery. In other words, each group of training data corresponds to one battery, and each group of training data includes three types of data corresponding to a same battery. Different groups of training data in the training data set may correspond to different batteries.

The first stage parameter includes a parameter of the battery in a procedure of undergoing a first stage process, the second stage parameter includes a parameter of the battery in a procedure of undergoing a second stage process, and the performance parameter of the battery is related to the first stage parameter and the second stage parameter.

In a possible embodiment, the first stage process includes a battery production process. The first stage parameter is a parameter obtained in a procedure of producing the battery, for example, parameters such as a formation voltage, a formation temperature, a quantity of electrolytes filled at a time, an open circuit voltage (that is, a potential difference between two electrodes when the battery is not discharged and is open-circuited), an open circuit resistance, a direct current internal resistance (Direct Current Internal Resistance, DCIR) and a roll core weight under specific load and a discharge current, and the like of the battery. In general, the first stage parameter represents various feature parameters of a battery in a production procedure, and these feature parameters are related to a capacity of the battery after production is completed.

The second stage process includes a battery capacity grading process. The second stage parameter includes a parameter of the battery in a procedure of undergoing the battery capacity grading process. Specifically, the battery capacity grading process is actually a process of performing procedures such as keeping static, charging, and discharging on the battery. Therefore, parameters of the battery in the procedure of undergoing the battery capacity grading process may be feature parameters of the battery at different moments in the procedure of undergoing the battery capacity grading process. The second stage parameter may include, for example, parameters such as states of charge, voltages, and temperatures of the battery at different moments. Because the battery capacity grading process takes a long time, the second stage parameter actually includes a large quantity of parameters such as states of charge, voltages, and temperatures at different moments.

The performance parameter of the battery may include a battery capacity, and the battery capacity may be a capacity determined after the battery undergoes the battery capacity grading process.

In another possible embodiment, the first stage process includes a first test of an OCV, the second stage process includes a second test of the OCV, and the performance parameter includes a battery self-discharge rate. The battery self-discharge rate is usually also referred to as a K value, and the K value is a physical quantity used to describe a cell self-discharge rate. The K value is calculated by dividing an open circuit voltage difference between the two tests of the OCV by a time interval between the two voltage tests. The formula is (OCV2-OCV1)/$\Delta$T. Generally, a K value test needs to be performed on a cell before delivery, and a cell with a larger K value (equivalent to self-discharging) is selected. Therefore, the first test of the OCV is actually to test an open circuit voltage of a battery after the battery is manufactured and kept static for a specific period of time (usually two days), and the second test of the OCV is actually to test the open circuit voltage of the battery again after a specific period of time (usually five to seven days) after the first test of the OCV. This means that it takes a long time to perform the two tests of the OCV on the battery, and test efficiency is low.

In general, the training data in the training data set is historical data, and can reflect various states of the battery in procedures of undergoing the first stage process and the second stage process, and the performance parameter of the battery.

Step 402: Process the first stage parameter by using a first network, to obtain a second stage prediction parameter of the battery, where the second stage parameter is a parameter that is obtained by the first network through prediction and that is of the battery in the procedure of undergoing the second stage process.

In this embodiment, the first network is a neural network, and is configured to predict, based on the first stage parameter of the battery, the parameter of the battery in the procedure of undergoing the second stage process, that is, the second stage prediction parameter of the battery. When the second stage process is a battery capacity grading process, the second stage prediction parameter of the battery may include, for example, parameters such as states of charge, voltages, and temperatures of the battery at different moments.

For example, the first network may be, for example, an MLP, a transformer, or a residual network. A structure of the first network is not specifically limited in this embodiment.

Step 403: Obtain a performance prediction parameter of the battery by using a second network based on the first stage parameter and an output result of the first network, where the output result of the first network is obtained based on the second stage prediction parameter.

Because the first network is configured to predict the parameter of the battery in the procedure of undergoing the second stage process, the output result of the first network is actually a feature of a parameter obtained through prediction.

In other words, in this step, the second network predicts the performance parameter of the battery based on the actual first stage parameter of the battery and the parameter that is predicted by the first network and that is of the battery in the procedure of undergoing the second stage process. In other words, inputs of the second network include the first stage parameter that is of the battery and that is in the training data set and the parameter that is obtained by the first network through prediction and that is in the procedure of the second stage process.

In a possible embodiment, the output result of the first network may be the second stage prediction parameter obtained by the first network through prediction. That is, an input of the second network is the first stage parameter of the battery and the second stage prediction parameter of the battery, and the second network predicts a battery capacity based on the parameters in the two different stages.

In another possible embodiment, the output result of the first network may be an output result of a feature extraction layer in the first network, and the output result is a second feature extracted by the feature extraction layer in the first network.

When the performance prediction parameter of the battery is obtained through prediction by using the second network, the first stage parameter of the battery may be first processed by using a feature extraction layer in the second network, to obtain a first feature, where the first feature represents a feature of the first stage parameter. Then, fusion processing is performed on the first feature and the second feature by using a feature fusion layer in the second network, to obtain the performance prediction parameter of the battery through prediction.

That is, the second feature output by the feature extraction layer of the first network is used as an input of the second network, so that the second network may perform fusion processing on the second feature and the first feature corresponding to the first stage parameter of the battery, and does not need to perform feature extraction on the second stage prediction parameter that is of the battery and that is obtained by the first network through prediction, thereby improving data processing efficiency of the second network.

In another possible embodiment, feature extraction may be first performed on the first stage parameter by using a third network, to obtain a first feature, where the first feature represents a feature of the first stage parameter. When the first feature is obtained by using the third network, in step 402, the first feature may be processed by using the first network, to obtain a second feature output by a feature extraction layer in the first network, where the second feature represents a feature of a parameter of the battery in the procedure of undergoing the second stage process. Then, fusion processing is performed on the first feature and the second feature by using the second network, to obtain the performance prediction parameter of the battery through prediction.

In other words, the third network is responsible for extracting the first feature corresponding to the first stage parameter of the battery; the first network is responsible for obtaining, through prediction, the second stage parameter of the battery based on the first feature extracted by the third network, and outputting the second feature extracted by the feature extraction layer; and the second network is responsible for performing fusion processing on the first feature extracted by the third network and the second feature extracted by the first network, to obtain the performance prediction parameter of the battery through prediction.

It should be noted that the second network may perform fusion processing on the first feature and the second feature in a plurality of manners. For example, the second network performs weighted summation on the first feature and the second feature, concatenates the first feature and the second feature, or directly processes both the first feature and the second feature by using a neural network layer. A manner in which the second network performs fusion processing on the first feature and the second feature is not limited in this embodiment.

The second network may be, for example, an MLP, a transformer, or a residual network. A structure of the second network is not specifically limited in this embodiment.

Step 404: Update the first network and the second network based on a first loss function and a second loss function.

The first loss function represents a difference between the second stage parameter and the second stage prediction parameter, and the second loss function represents a difference between the performance parameter of the battery and the performance prediction parameter. In other words, the first loss function is constructed based on the second stage parameter that is of the battery and that is in the training data set and the second stage prediction parameter that is of the battery and that is obtained by the first network through prediction, and is used to evaluate accuracy of predicting the second stage parameter of the battery by the first network. The second loss function is constructed based on the actual performance parameter that is of the battery and that is in the training data set and the performance prediction parameter that is of the battery and that is obtained by the second network through prediction, and is used to evaluate accuracy of predicting the performance parameter of the battery by the second network.

In a possible embodiment, the first loss function may be used to update only the first network, and the second loss function may be used to update only the second network. In other words, the first network and the second network may be considered as two independent networks, and the first network and the second network are independently updated.

In another possible embodiment, weighted summation may be performed on the first loss function and the second loss function to obtain a total loss function, and then the first network and the second network are updated based on the total loss function. In other words, the first network and the second network may be considered as being used to form a total network model, and form the total loss function based on loss functions corresponding to the two networks, so that the two networks are updated together based on the total loss function. A manner of updating the first network and the second network based on the first loss function and the second loss function is not limited in this embodiment.

In this solution, the first network obtains, through prediction, the second stage parameter of the battery based on the first stage parameter of the battery under supervision of the actual second stage parameter of the battery, and the second network predicts performance of the battery with reference to the first stage parameter of the battery and the second stage parameter that is obtained by the first network through prediction and that is of the battery. Because the first network is obtained through training under supervision of the actual second stage parameter of the battery, accuracy of the second stage parameter that is of the battery and that is predicted by the first network can be effectively ensured. In addition, the second network predicts the performance of the battery by fusing parameters of the battery in the first stage process and the second stage process, so that prediction accuracy of the performance of the battery can be effectively ensured. Moreover, a network model finally obtained through training does not depend on the second stage parameter of the battery when predicting a battery capacity, thereby omitting a procedure of performing the second stage process on the battery.

Optionally, in step 403, when the second network performs feature fusion processing based on the second feature output by the first network, in the model training method, a loss function may be additionally constructed to constrain the second feature output by the first network. Specifically, in the model training method, a third feature corresponding to the second stage parameter that is of the battery and that is in the training data set may be extracted; and then, a third loss function is constructed based on the third feature and the second feature output by the first network, and the first network is updated based on the third loss function, where the third loss function represents a difference between the second feature and the third feature.

The third feature corresponding to the second stage parameter that is of the battery and that is in the training data set may be extracted by using a neural network. For example, the neural network may be a network including an encoder structure and a decoder structure, and the neural network performs feature extraction on the second stage parameter of the battery by using the encoder structure, and restores the extracted feature to an input of the neural network (that is, the second stage parameter of the battery) by using the decoder structure.

In this solution, the third loss function is constructed to represent a difference between a feature extracted by the first network and an actual feature of the second stage parameter of the battery, and the first network is trained based on the third loss function, so that the feature extracted by the first network can be as close as possible to the feature of the second stage parameter, to ensure accuracy of subsequently predicting the performance parameter of the battery by the second network based on an output of the first network.

The foregoing describes the model training method provided in embodiments of this application. The following describes a procedure of predicting battery performance based on a network model obtained through training by using the foregoing model training method.

FIG. 5 is a schematic flowchart of a battery performance prediction method according to an embodiment of this application. As shown in FIG. 5, a procedure of the battery performance prediction method includes the following steps 501 to 503.

Step 501: Obtain a first stage parameter of a battery, where the first stage parameter includes a parameter of the battery in a procedure of undergoing a first stage process.

The battery in this embodiment may be a battery whose performance parameter is to be predicted, for example, a battery that has been manufactured and on which a battery capacity grading process has not been performed, or a battery on which a first test of an OCV has been performed and a second test of the OCV has not been performed. In this embodiment, the performance parameter of the battery is predicted by using the battery performance prediction method, to avoid performing a second stage process on the battery.

Step 502: Process the first stage parameter by using a first network, to obtain a second stage result of the battery, where the second stage result is obtained based on a second stage parameter, the second stage parameter is a parameter that is predicted by the first network and that is of the battery in a procedure of undergoing the second stage process, and the second stage process is performed after the first stage process.

For descriptions of the first stage process and the second stage process, refer to the foregoing steps 401 and 402. Details are not described herein again.

In this step, the first network may be, for example, a neural network obtained through training by using the foregoing model training method, and is configured to predict, based on the first stage parameter of the battery, the parameter of the battery in the procedure of undergoing the second stage process.

In a possible embodiment, the second stage result of the battery obtained after the first network processes the first stage parameter of the battery may be the second stage parameter obtained by the first network through prediction, and the second stage parameter is the parameter of the battery in the procedure of undergoing the second stage process.

In another possible embodiment, the second stage result of the battery obtained after the first network processes the first stage parameter of the battery may be, for example, an output result of a feature extraction layer in the first network, and the output result is a second feature extracted by the feature extraction layer in the first network.

In another possible embodiment, feature extraction may be first performed on the first stage parameter by using a third network, to obtain a first feature, where the first feature represents a feature of the first stage parameter. When the first feature is obtained by using the third network, the first feature is processed by using the first network, to obtain a second feature output by a feature extraction layer in the first network, where the second feature represents a feature of the parameter of the battery in the procedure of undergoing the second stage process.

Step 503: Obtain, through prediction, the performance parameter of the battery by using a second network based on the first stage parameter and the second stage result.

Because the first network is configured to predict the parameter of the battery in the procedure of undergoing the second stage process, the output result of the first network is actually a feature of a parameter obtained through prediction.

In other words, in this step, the second network predicts battery performance based on the actual first stage parameter of the battery and the parameter that is predicted by the first network and that is of the battery in the procedure of undergoing the second stage process. In other words, inputs of the second network include the first stage parameter that is of the battery and that is in a training data set and the parameter that is obtained by the first network through prediction and that is in the procedure of the second stage process.

When the second stage result is a second stage prediction parameter obtained by the first network through prediction, inputs of the second network are the first stage parameter of the battery and the second stage prediction parameter of the battery, and the second network predicts the battery performance based on parameters in the two different stages.

When the second stage result is the second feature extracted by the feature extraction layer in the first network, and a performance prediction parameter of the battery is obtained through prediction by using the second network, the first stage parameter of the battery may be first processed by using a feature extraction layer in the second network, to obtain a first feature, where the first feature represents a feature of the first stage parameter. Then, fusion processing is performed on the first feature and a second feature by using a feature fusion layer in the second network, to obtain the performance parameter of the battery through prediction.

That is, the second feature output by the feature extraction layer of the first network is used as an input of the second network, so that the second network may perform fusion processing on the second feature and the first feature corresponding to the first stage parameter of the battery, and does not need to perform feature extraction on the second stage prediction parameter that is of the battery and that is obtained by the first network through prediction, thereby improving data processing efficiency of the second network.

When the first feature is obtained by performing feature extraction on the first stage parameter by using the third network, fusion processing may be performed, by using the second network, on the first feature extracted by the third network and the second feature extracted by the first network, to obtain the performance prediction parameter of the battery through prediction. In other words, the third network is responsible for extracting the first feature corresponding to the first stage parameter of the battery; the first network is responsible for obtaining, through prediction, the second stage prediction parameter of the battery based on the first feature extracted by the third network, and outputting the second feature extracted by the feature extraction layer; and the second network is responsible for performing fusion processing on the first feature extracted by the third network and the second feature extracted by the first network, to obtain the performance prediction parameter of the battery through prediction.

In this embodiment of this application, the first network first predicts the parameter of the battery in the procedure of the second stage process based on the parameter of the battery in the procedure of the first stage process, and then fuses the parameter of the battery in the procedure of the first stage process with the parameter that is obtained through prediction and that is of the battery in the procedure of the second stage process, and the second network predicts the performance parameter of the battery based on a plurality of features of the battery, thereby effectively improving prediction accuracy of the performance parameter of the battery. In this solution, the performance parameter of the battery is predicted by fusing the first stage parameter of the battery with the second stage parameter that is obtained through prediction and that is of the battery. This can avoid performing the second stage process on the battery while ensuring prediction accuracy of the performance parameter of the battery, thereby effectively improving efficiency of determining the performance parameter of the battery and reducing costs for determining the performance parameter of the battery.

The foregoing describes the model training method and the battery performance prediction method provided in embodiments of this application. For ease of understanding, the following describes in detail specific procedures of training a network and predicting a battery capacity based on a network obtained through training with reference to specific examples. In addition, in the following examples, an example in which a first stage process is a battery production process, the first stage parameter is a battery production parameter, a second stage process is a battery capacity grading process, and a second stage parameter is a battery capacity grading stage parameter is used for description.

Specifically, in embodiments, a battery capacity may be predicted by using a plurality of different network structures. The following separately describes procedures of training and using the plurality of different network structures.

Implementation 1:

In Implementation 1, a network structure used to predict a battery capacity includes a first network and a second network, the first network is configured to predict a capacity grading stage parameter of a battery based on a battery production parameter, and the second network is configured to predict the battery capacity based on the battery production parameter and the capacity grading stage parameter predicted by the first network.

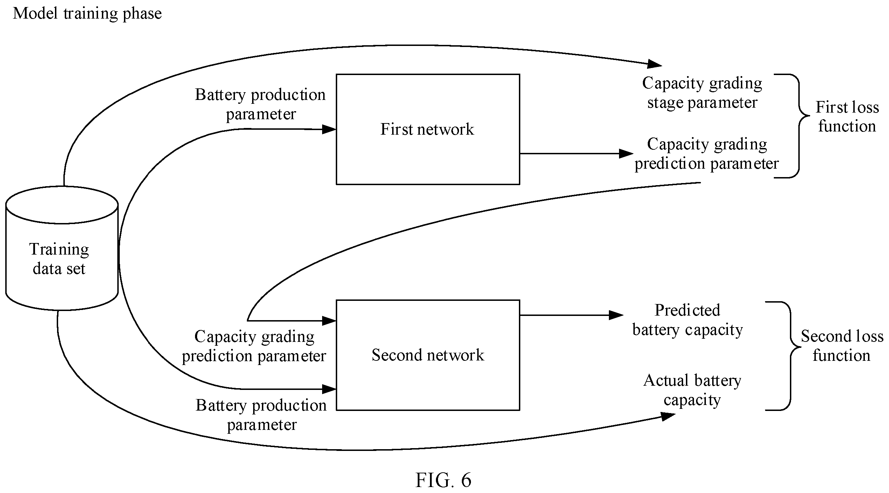

For example, FIG. 6 is a diagram of a model training phase according to an embodiment of this application. As shown in FIG. 6, a network structure used to predict a battery capacity includes a first network and a second network. A training data set used to train the first network and the second network includes a battery production parameter, a capacity grading stage parameter of a battery, and an actual battery capacity. The capacity grading stage parameter of the battery is a parameter of the battery in a procedure of undergoing a battery capacity grading process.

In the model training phase, the battery production parameter in the training data set is input into the first network, and the first network obtains a capacity grading stage prediction parameter of the battery (referred to as a capacity grading prediction parameter for short below) based on the battery production parameter. Then, a first loss function is constructed based on the capacity grading stage parameter that is of the battery and that is in the training data set and the capacity grading prediction parameter output by the first network. The first loss function represents a difference between an actual capacity grading stage parameter of the battery and the capacity grading prediction parameter output by the first network.

Then, both the capacity grading prediction parameter output by the first network and the battery production parameter in the training data set are input into the second network, and the second network predicts a battery capacity based on the capacity grading prediction parameter and the battery production parameter, to obtain the predicted battery capacity. Then, a second loss function is constructed based on the actual battery capacity in the training data set and the predicted battery capacity output by the second network. The second loss function represents a difference between the actual battery capacity and the predicted battery capacity output by the second network.

Finally, the first network and the second network are updated based on the first loss function and the second loss function by using a back propagation algorithm. Specifically, in a model update procedure, the first network may be independently updated based on the first loss function, and the second network may be independently updated based on the second loss function; or the first network and the second network may be updated with reference to both the first loss function and the second loss function.

The first network and the second network each may be, for example, an MLP, a transformer, or a residual network. Structures of the first network and the second network are not specifically limited in this embodiment.

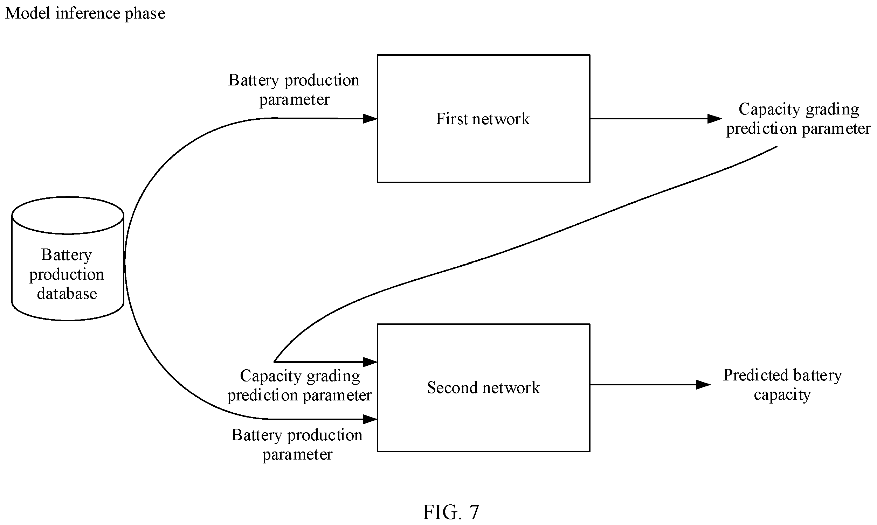

For example, FIG. 7 is a diagram of a model inference phase according to an embodiment of this application. As shown in FIG. 7, after a network structure is trained in the model training manner shown in FIG. 6, a first network and a second network shown in FIG. 7 are obtained. In FIG. 7, in the model inference phase, a battery production database may be obtained. The battery production database includes parameters of batteries in a production procedure. A battery production parameter in the battery production database is input into the first network, to obtain a capacity grading prediction parameter output by the first network. Then, both the capacity grading prediction parameter output by the first network and the battery production parameter in the battery production database are input into the second network, to obtain a predicted battery capacity output by the second network.

Implementation 2:

In Implementation 2, a network structure used to predict a battery capacity includes a first network and a second network, the first network is configured to predict a capacity grading stage parameter of a battery based on a battery production parameter, and the second network is configured to predict the battery capacity based on the battery production parameter and an intermediate feature extracted by the first network.

In Implementation 2, the first network and the second network may be trained in two different manners.

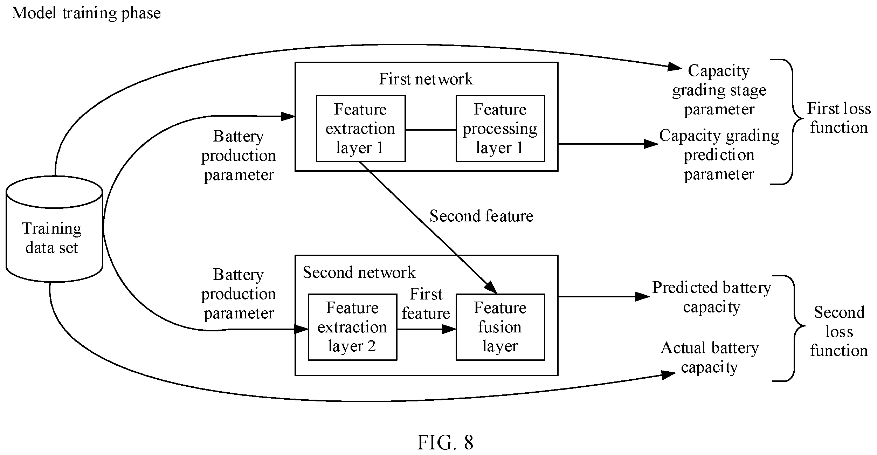

In a possible example, FIG. 8 is a diagram of another model training phase according to an embodiment of this application. As shown in FIG. 8, a network structure used to predict a battery capacity includes a first network and a second network. The first network includes a feature extraction layer 1 and a feature processing layer 1, and the second network includes a feature extraction layer 2 and a feature fusion layer. A training data set used to train the first network and the second network includes a battery production parameter, a capacity grading stage parameter of a battery, and an actual battery capacity.

In the model training phase, the battery production parameter in the training data set is input into the first network, and the feature extraction layer 1 in the first network performs feature extraction on the battery production parameter to obtain a second feature. The second feature represents a feature of a parameter of the battery in a procedure of undergoing a battery capacity grading process. Then, the feature processing layer 1 in the first network processes the second feature, to obtain a capacity grading prediction parameter. Then, a first loss function is constructed based on the capacity grading stage parameter that is of the battery and that is in the training data set and the capacity grading prediction parameter output by the first network. The first loss function represents a difference between an actual capacity grading stage parameter of the battery and the capacity grading prediction parameter output by the first network.

Then, the battery production parameter in the training data set is input into the second network, and the feature extraction layer 2 in the second network extracts a first feature. The first feature represents a feature of the battery production parameter. The first feature and the second feature are input into the feature fusion layer 2 in the second network, and the feature fusion layer 2 in the second network fuses the first feature and the second feature, and predicts the battery capacity, to obtain the predicted battery capacity. Then, a second loss function is constructed based on the actual battery capacity in the training data set and the predicted battery capacity output by the second network. The second loss function represents a difference between the actual battery capacity and the predicted battery capacity output by the second network.

Finally, the first network and the second network are updated based on the first loss function and the second loss function by using a back propagation algorithm. Specifically, in a model update procedure, the first network may be independently updated based on the first loss function, and the second network may be independently updated based on the second loss function; or the first network and the second network may be updated with reference to both the first loss function and the second loss function.

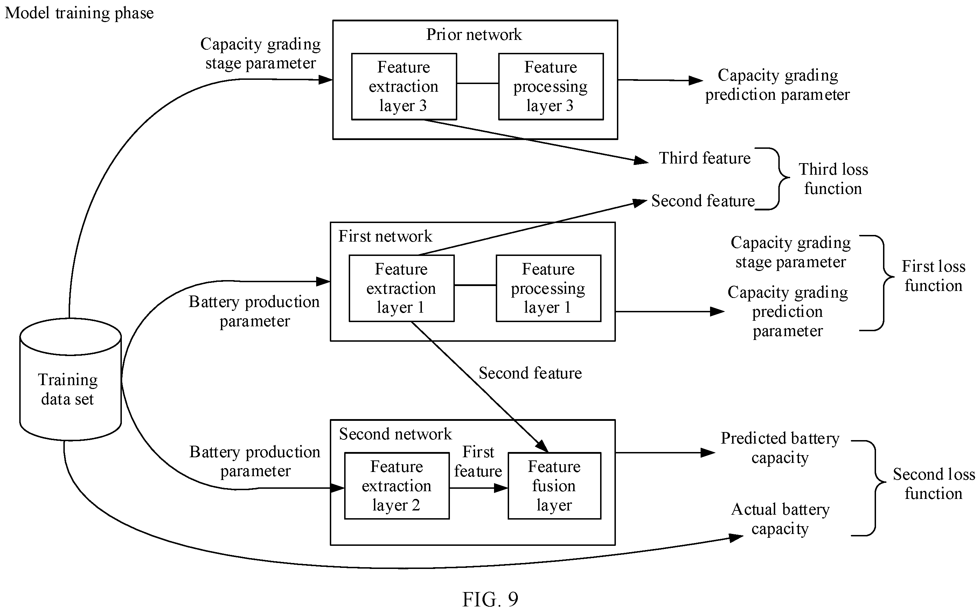

In another possible example, FIG. 9 is a diagram of another model training phase according to an embodiment of this application. As shown in FIG. 9, a network structure used to predict a battery capacity includes a first network, a second network, and a prior network. The first network includes a feature extraction layer 1 and a feature processing layer 1, the second network includes a feature extraction layer 2 and a feature fusion layer, and the prior network includes a feature extraction layer 3 and a feature processing layer 3. The prior network may be a pretrained network. An input of the prior network is a capacity grading stage parameter of a battery, and an output of the prior network is a capacity grading prediction parameter of the battery. That is, the prior network is actually configured to perform feature extraction on the capacity grading stage parameter of the battery by using the feature extraction layer 3, and then restore the extracted feature by using the feature processing layer 3. Therefore, a third feature extracted by the prior network by using the feature extraction layer 3 can well represent a feature of the capacity grading stage parameter of the battery.

In the embodiment shown in FIG. 9, inputs and outputs of the first network and the second network are the same as those in the embodiment shown in FIG. 8. Therefore, in the embodiment shown in FIG. 9, a first loss function and a second loss function may be obtained in a manner the same as that in the embodiment shown in FIG. 8. In addition, in FIG. 9, after the feature extraction layer 3 in the prior network extracts the third feature corresponding to the capacity grading stage parameter, and the first network extracts a second feature based on the battery production parameter, a third loss function may be constructed based on the second feature and the third feature. The third loss function represents a difference between the second feature extracted by the first network and the third feature extracted by the third network. In other words, in FIG. 9, a feature extracted by the first network is supervised by using a feature that is of a capacity grading stage and that is extracted by the prior network, to ensure that the feature extracted by the first network can be closer to a feature of an actual capacity grading stage parameter.

Finally, the first network may be updated based on the first loss function and the third loss function, and the second network may be updated based on the second loss function.

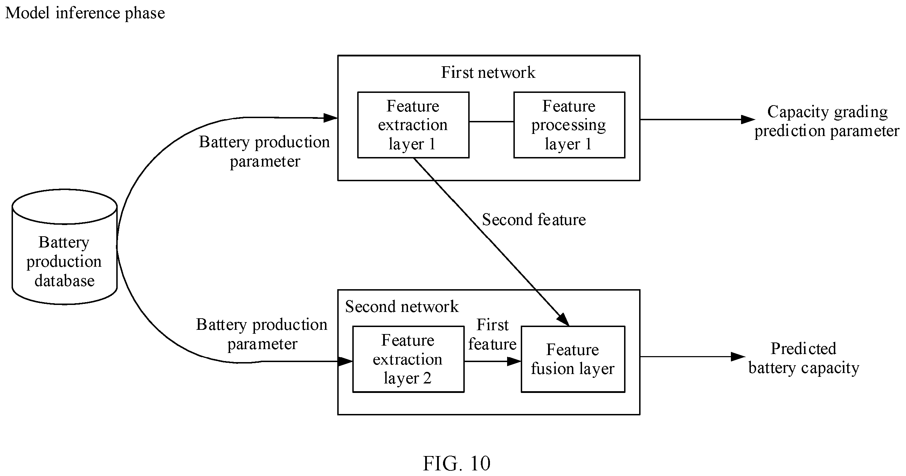

For example, FIG. 10 is a diagram of another model inference phase according to an embodiment of this application. As shown in FIG. 10, after a network structure is trained in the model training manner shown in FIG. 8 or FIG. 9, a first network and a second network shown in FIG. 10 are obtained. In FIG. 10, in the model inference phase, a battery production database may be obtained. The battery production database includes parameters of batteries in a production procedure. A battery production parameter in the battery production database is input into the first network, to obtain a second feature output by a feature extraction layer 1 in the first network. Then, the battery production parameter in the battery production database is input into the second network, to obtain a first feature output by a feature extraction layer 2 in the second network; and then both the first feature and the second feature are input into a feature fusion layer in the second network for fusion processing, to obtain a predicted battery capacity output by the second network.

Implementation 3:

In Implementation 3, a network structure used to predict a battery capacity includes a first network, a second network, and a third network, the third network is configured to extract a feature of a battery production parameter, the first network is configured to predict a capacity grading stage parameter of a battery based on the feature of the battery production parameter, and the second network is configured to predict the battery capacity based on the feature of the battery production parameter and an intermediate feature extracted by the first network.

Simply speaking, compared with Implementation 2, the third network is added in Implementation 3, and the third network is configured to extract the feature of the battery production parameter.

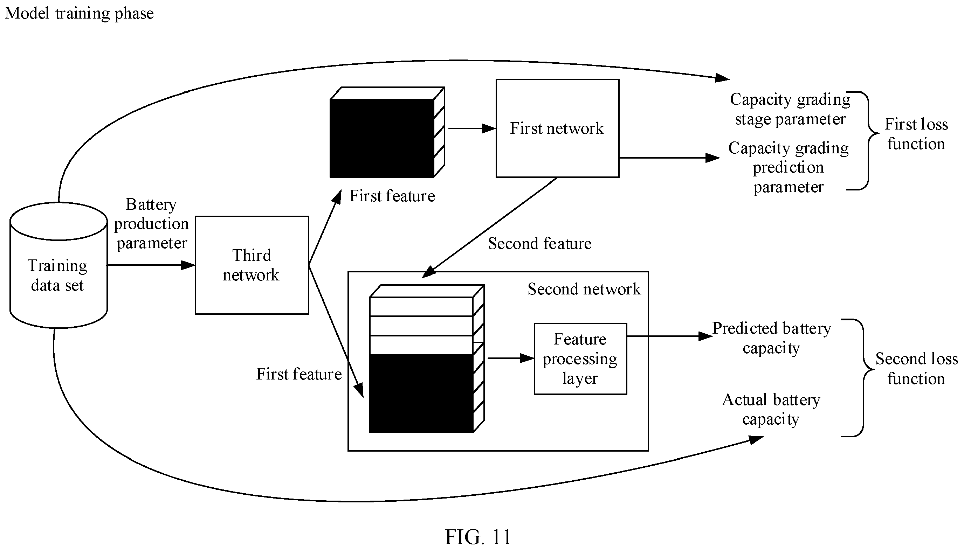

In a possible example, FIG. 11 is a diagram of another model training phase according to an embodiment of this application. As shown in FIG. 11, a network structure used to predict a battery capacity includes a first network, a second network, and a third network.

In the model training phase, a battery production parameter in a training data set is input into the third network, and a feature extraction layer in the third network performs feature extraction on the battery production parameter, to obtain a first feature. The first feature represents a feature of the battery production parameter. Then, the first feature is input into the first network, and the first network processes the first feature, to obtain a capacity grading prediction parameter. Then, a first loss function is constructed based on a capacity grading stage parameter that is of the battery and that is in the training data set and the capacity grading prediction parameter output by the first network. The first loss function represents a difference between an actual capacity grading stage parameter of the battery and the capacity grading prediction parameter output by the first network. The first network may include the feature extraction layer that can further perform feature extraction on the first feature, to obtain a second feature that represents the capacity grading stage parameter.

Then, the first feature extracted by the third network and the second feature extracted by the first network are input into the second network, and the first feature and the second feature are fused in the second network to predict the battery capacity, to obtain the predicted battery capacity. A manner in which the second network fuses the first feature and the second feature is splicing the first feature and the second feature. Then, a second loss function is constructed based on an actual battery capacity in the training data set and the predicted battery capacity output by the second network. The second loss function represents a difference between the actual battery capacity and the predicted battery capacity output by the second network.

Finally, the first network and the second network are updated based on the first loss function and the second loss function by using a back propagation algorithm. Specifically, in a model update procedure, the first network may be independently updated based on the first loss function, and the second network may be independently updated based on the second loss function; or the first network and the second network may be updated with reference to both the first loss function and the second loss function.

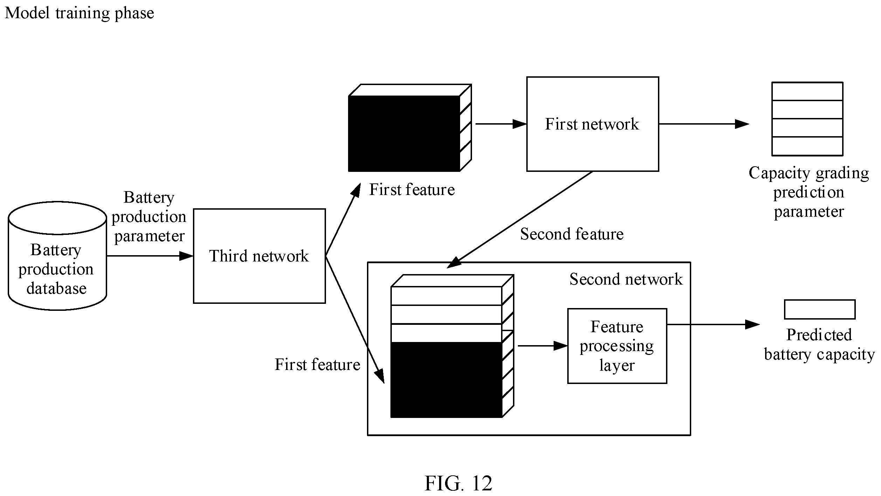

For example, FIG. 12 is a diagram of another model inference phase according to an embodiment of this application. As shown in FIG. 12, after a network structure is trained in the model training manner shown in FIG. 11, a first network, a second network, and a third network shown in FIG. 12 are obtained. In FIG. 12, in the model inference phase, a battery production database may be obtained. The battery production database includes parameters of batteries in a production procedure. A battery production parameter in the battery production database is input into the third network, to obtain a first feature output by the third network. The first feature represents a feature of the battery production parameter. Then, the first feature is input into the first network, to obtain a second feature extracted by the first network. The second feature represents a feature of a parameter of a battery in a procedure of undergoing a battery capacity grading process. Then, the first feature and the second feature are input into the second network, and the first feature and the second feature are fused in the second network, to obtain a predicted battery capacity output by the second network.

The foregoing describes procedures of predicting the capacity grading stage parameter of the battery based on the battery production parameter, and then predicting the battery capacity based on the battery production parameter and the capacity grading stage parameter of the battery. However, when there are a large quantity of capacity grading stage parameters of the battery (that is, there are a large quantity of parameters of the battery in a procedure of undergoing a battery capacity grading process), because a quantity of battery production parameters is not large, it may be difficult to effectively obtain, through prediction, the large quantity of capacity grading stage parameters of the battery based on the battery production parameters. For example, it is assumed that there are 15 battery production parameters in total, and there are 30 capacity grading stage parameters of the battery (that is, parameters such as states of charge, voltages, and temperatures of the battery at different moments in the procedure of undergoing the battery capacity grading process) in total. In this case, it may be difficult to accurately obtain, through prediction, the 30 capacity grading stage parameters of the battery based on the 15 battery production parameters.

Based on this, in embodiments, some capacity grading stage parameters of the battery may be predicted based on the battery production parameters, and the some capacity grading stage parameters of the battery are parameters that are in all capacity grading stage parameters of the battery and that have a large degree of contribution to the prediction of the battery capacity.

For example, based on the foregoing embodiments, the battery corresponds to M parameters in total in the procedure of undergoing the battery capacity grading process, and the first network may be specifically configured to predict N target parameters of the battery in the procedure of undergoing the battery capacity grading process. The N target parameters are N parameters that are in the M parameters and that have a largest degree of contribution to the prediction of the battery capacity, both M and N are integers greater than or equal to 1, and N is less than or equal to M.

In other words, for a battery, M parameters (that is, capacity grading stage parameters) may be obtained through measurement when the battery undergoes the procedure of the battery capacity grading process. N target parameters that have a largest degree of contribution to the prediction of the battery capacity may be selected from the M parameters. N may be a preset threshold. For example, M is 30, and N is 15.

In this solution, some parameters that have a large degree of contribution to the prediction of the battery capacity are selected from a plurality of capacity grading stage parameters of the battery, so that prediction of highdimensional data based on low-dimensional data can be avoided, and prediction accuracy of the first network can be improved, thereby improving prediction accuracy of the battery capacity.

Specifically, the following describes how to obtain a degree of contribution of each battery in the M parameters to the prediction of the battery capacity.

For example, a regression model may be obtained. The regression model represents a relationship between the battery capacity, and a parameter of the battery in a production procedure and a parameter of the battery in a procedure of a battery capacity grading process. In other words, the regression model may predict the battery capacity based on the parameter of the battery in the production procedure and the parameter of the battery in the procedure of the battery capacity grading process. The regression model may be a linear mathematical model or a neural network model.

Then, the degree of contribution of each of the M parameters to the prediction of the battery capacity is obtained based on the regression model, and the N target parameters that have a largest degree of contribution are determined from the M parameters based on the degree of contribution of each parameter to the prediction of the battery capacity. Because the regression model may be used to predict the battery capacity based on the parameter of the battery in the production procedure and the parameter of the battery in the procedure of the battery capacity grading process, when the regression model is used to predict the battery capacity based on the parameter of the battery in the production procedure and the parameter of the battery in the procedure of the battery capacity grading process, the degree of contribution of each parameter to the prediction of the battery capacity may be determined by determining a proportion of contribution of each parameter to the prediction of the battery capacity.

For example, when the regression model is a linear mathematical model, the linear regression model may be fitted based on the battery production parameter, a parameter of the battery in the procedure of the capacity grading process, and the battery capacity that are in the training data set. The battery capacity is a dependent variable Y, and the battery production parameter and the parameter of the battery in the procedure of the capacity grading process are dependent variables X. In this case, the linear regression model $Y=A1 \times X1+A2 \times X2+A3 \times X3... An \times Xn$ may be obtained through fitting. Y represents the battery capacity, X1, X2, ..., and Xn represent the battery production parameter and the parameter of the battery in procedure of the capacity grading process, and A1, A2, ..., and An represent weights of the parameters. In this way, a weight corresponding to each parameter may be considered as a degree of contribution of each parameter to the prediction of the battery capacity. The N target parameters with the largest degree of contribution (that is, a largest weight) may be selected by comparing the weights of the parameters.

For another example, when the regression model is a neural network model, the battery production parameter and the parameter of the battery in the procedure of the capacity grading process that are in the training data set may be used as inputs of the regression model, and the battery capacity may be used as an output of the regression model, to train the regression model. After the regression model is trained, the degree of contribution of each parameter to the prediction of the battery capacity may be obtained based on a manner of predicting the battery capacity by using the regression model, and then the N target parameters with the largest degree of contribution are selected.

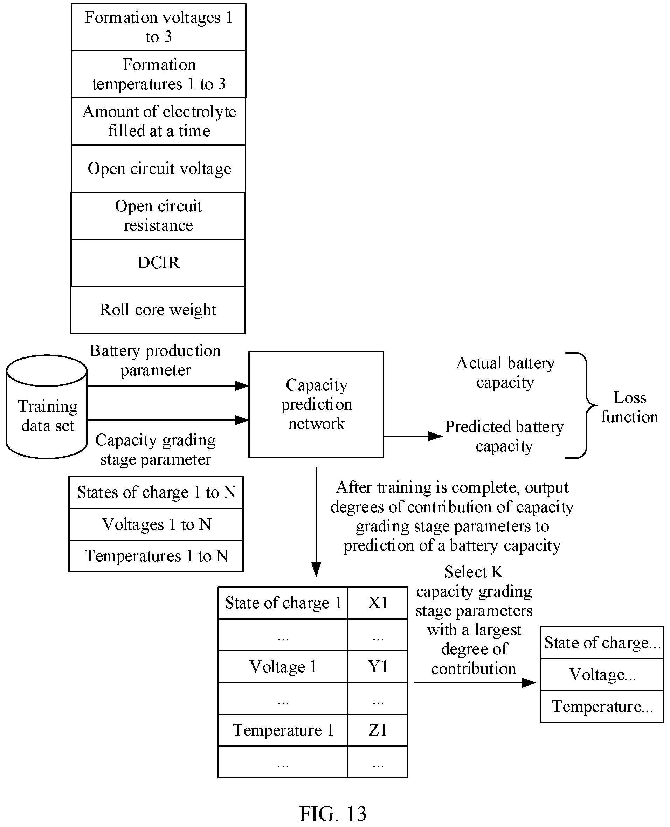

For example, FIG. 13 is a schematic flowchart of screening out a capacity grading stage parameter according to an embodiment of this application. As shown in FIG. 13, a capacity prediction network is first constructed, and the capacity prediction network is a neural network model. When the capacity prediction network is trained, a battery production parameter and a capacity grading stage parameter that are in a training data set, for example, battery production parameters such as formation voltages 1 to 3 (that is, voltages at a moment 1 to a moment 3), formation temperatures 1 to 3, a quantity of electrolytes filled at a time, an open circuit voltage, an open circuit resistance, a DCIR, and a roll core weight, and capacity grading stage parameters such as states of charge 1 to N (that is, states of charge at a moment 1 to a moment N), voltages 1 to N, and the voltages 1 to N are input into the capacity prediction network, to obtain a predicted battery capacity output by the capacity prediction network. Then, a loss function is constructed based on an actual battery capacity in the training data set and the predicted battery capacity, to train the capacity prediction network.

After training of the capacity prediction network is completed, degrees of contribution of capacity grading stage parameters to the prediction of the battery capacity may be obtained based on a manner of predicting the battery capacity by using the capacity prediction network. Then, the capacity grading stage parameters are sorted in descending order of the degrees of contribution, and K capacity grading stage parameters with a largest degree of contribution are finally selected as capacity grading stage parameters that need to be predicted by the first network.

It may be understood that the foregoing describes, by using an example of predicting a battery capacity, a procedure of screening out a capacity grading stage parameter of a battery. In an actual application procedure, another performance parameter of the battery may alternatively be predicted, and then parameters of the battery in a procedure of a second stage process are screened. A screening manner is similar to a screening manner of the capacity grading stage parameters of the battery. Details are not described herein again.

The foregoing describes in detail the methods provided in embodiments of this application. The following describes devices that are provided in embodiments of this application and that are configured to perform the foregoing methods.

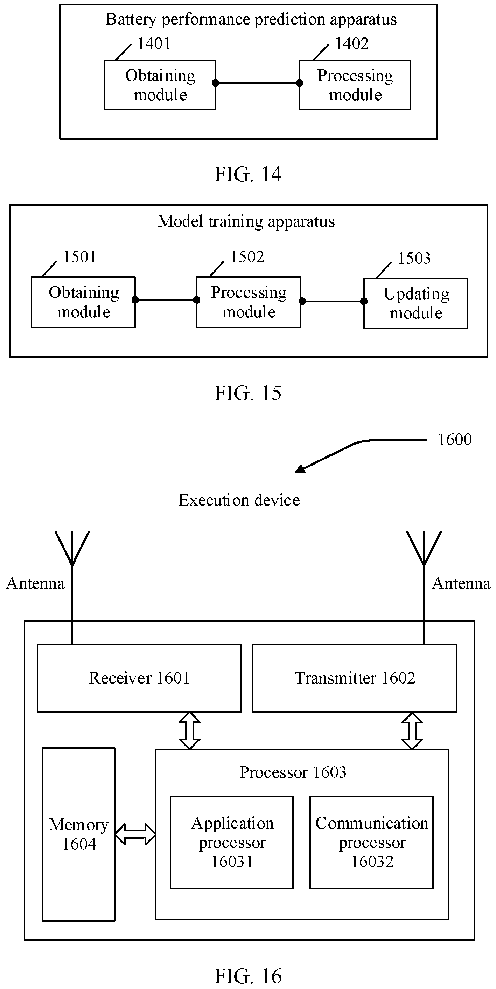

FIG. 14 is a diagram of a structure of a battery performance prediction apparatus according to an embodiment of this application. As shown in FIG. 14, the battery performance prediction apparatus includes:

an obtaining module 1401, configured to obtain a first stage parameter of a battery, where the first stage parameter includes a parameter of the battery in a procedure of undergoing a first stage process; and

a processing module 1402, configured to process the first stage parameter by using a first network, to obtain a second stage result of the battery, where the second stage result is obtained based on a second stage parameter, the second stage parameter is a parameter that is predicted by the first network and that is of the battery in a procedure of undergoing a second stage process, and the second stage process is performed after the first stage process.

The processing module 1402 is further configured to obtain, through prediction, a performance parameter of the battery based on the first stage parameter and the second stage result by using a second network.

In a possible implementation, the first stage process includes a battery production process, the second stage process includes a battery capacity grading process, and the performance parameter includes a battery capacity.

Alternatively, the first stage process includes a first test of an OCV, the second stage process includes a second test of the OCV, and the performance parameter includes a battery self-discharge rate.

In a possible implementation, the second stage result is the second stage parameter obtained by the first network through prediction, and the second stage parameter is the parameter of the battery in the procedure of undergoing the second stage process.

In a possible implementation, the processing module 1402 is further configured to:

process the first stage parameter by using a feature extraction layer in the second network, to obtain a first feature; and

perform fusion processing on the first feature and a second feature by using a feature fusion layer in the second network, to obtain the performance parameter of the battery through prediction.

The second feature is the second stage result output by a feature extraction layer in the first network.

In a possible implementation, the processing module 1402 is further configured to:

perform feature extraction on the first stage parameter by using a third network, to obtain a first feature;

process the first feature by using the first network, to obtain the second stage result, where the second stage result is a second feature output by a feature extraction layer in the first network; and

perform fusion processing on the first feature and the second feature by using the second network, to obtain the performance parameter of the battery through prediction.

In a possible implementation, the first network is specifically configured to predict N target parameters of the battery in the procedure of undergoing the second stage process.

The battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In a possible implementation, the obtaining module 1401 is further configured to obtain a regression model, where the regression model represents a relationship between the performance parameter of the battery, and the parameter of the battery in the procedure of undergoing the first stage process and the parameter of the battery in the procedure of undergoing the second stage process.

The processing module 1402 is further configured to obtain, based on the regression model, a degree of contribution of each of the M parameters to the prediction of the performance parameter of the battery.

The processing module 1402 is further configured to determine the N target parameters from the M parameters based on the degree of contribution of each parameter to the prediction of the performance parameter of the battery.

FIG. 15 is a diagram of a structure of a model training apparatus according to an embodiment of this application. As shown in FIG. 15, the model training apparatus includes:

an obtaining module 1501, configured to obtain a training data set, where the training data set includes a first stage parameter, a second stage parameter, and a performance parameter that are of a same battery, the first stage parameter includes a parameter of the battery in a procedure of undergoing a first stage process, and the second stage parameter includes a parameter of the battery in a procedure of undergoing a second stage process;

a processing module 1502, configured to process the first stage parameter by using a first network, to obtain a second stage prediction parameter of the battery, where the second stage parameter is a parameter that is obtained by the first network through prediction and that is of the battery in the procedure of undergoing the second stage process, where the processing module 1502 is further configured to obtain a performance prediction parameter of the battery by using a second network based on the first stage parameter and an output result of the first network; and

an updating module 1503, configured to update the first network and the second network based on a first loss function and a second loss function.

The first loss function represents a difference between the second stage parameter and the second stage prediction parameter, and the second loss function represents a difference between the performance parameter of the battery and the performance prediction parameter.

In a possible implementation, the first stage process includes a battery production process, and the second stage process includes a battery capacity grading process.

Alternatively, the first stage process includes a first test of an open circuit voltage OCV, and the second stage process includes a second test of the OCV.

In a possible implementation, the output result of the first network is the second stage prediction parameter obtained by the first network through prediction.

In a possible implementation, the processing module 1502 is further configured to:

process the first stage parameter by using a feature extraction layer in the second network, to obtain a first feature; and
perform fusion processing on the first feature and a second feature by using a feature fusion layer in the second network, to obtain the performance prediction parameter of the battery.

The second feature is an output result of a feature extraction layer in the first network.

In a possible implementation, the processing module 1502 is further configured to extract a third feature corresponding to the second stage parameter of the battery.

The updating module 1503 is further configured to update the first network based on a third loss function, where the third loss function represents a difference between the second feature and the third feature.

In a possible implementation, the processing module 1502 is further configured to:

perform feature extraction on the first stage parameter by using a third network, to obtain a first feature;
process the first feature by using the first network, to obtain a second feature output by a feature extraction layer in the first network; and
perform fusion processing on the first feature and the second feature by using the second network, to obtain the performance prediction parameter of the battery.

In a possible implementation, the first network is specifically configured to predict N target parameters of the battery in the procedure of undergoing the second stage process.

The battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

In a possible implementation, the obtaining module 1501 is further configured to obtain a regression model, where the regression model represents a relationship between the performance parameter of the battery, and the parameter of the battery in the procedure of undergoing the first stage process and the parameter of the battery in the procedure of undergoing the second stage process.

The processing module 1502 is further configured to obtain, based on the regression model, a degree of contribution of each of the M parameters to the prediction of the performance parameter of the battery.

The processing module 1502 is further configured to determine the N target parameters from the M parameters based on the degree of contribution of each parameter to the prediction of the performance parameter of the battery.

FIG. 16 is a diagram of a structure of an execution device according to an embodiment of this application. An execution device 1600 may be specifically represented as a mobile phone, a tablet computer, a notebook computer, an intelligent wearable device, a server, or the like. This is not limited herein. Specifically, the execution device 1600 includes a receiver 1601, a transmitter 1602, a processor 1603 and a memory 1604 (there may be one or more processors 1603 in the execution device 1600, and one processor is used as an example in FIG. 16). The processor 1603 may include an application processor 16031 and a communication processor 16032. In some embodiments of this application, the receiver 1601, the transmitter 1602, the processor 1603, and the memory 1604 may be connected by using a bus or in another manner.

The memory 1604 may include a read-only memory and a random access memory, and provide instructions and data to the processor 1603. A part of the memory 1604 may further include a non-volatile random access memory (non-volatile random access memory, NVRAM). The memory 1604 stores a processor and operation instructions, an executable module or a data structure, a subset thereof, or an extended set thereof. The operation instructions may include various operation instructions for implementing various operations.

The processor 1603 controls an operation of the execution device. In a specific application, components of the execution device are coupled together through a bus system. In addition to a data bus, the bus system may further include a power bus, a control bus, a status signal bus, and the like. However, for clear description, various types of buses in the figure are referred to as the bus system.

The methods disclosed in embodiments of this application may be applied to the processor 1603 or may be implemented by the processor 1603. The processor 1603 may be an integrated circuit chip and has a signal processing capability. In an implementation procedure, steps in the foregoing methods may be implemented by using a hardware integrated logic circuit in the processor 1603, or by using instructions in a form of software. The processor 1603 may be a general-purpose processor, a digital signal processor (digital signal processor, DSP), and may further include a microprocessor or a microcontroller, an application-specific integrated circuit (application-specific integrated circuit, ASIC), a field-programmable gate array (field-programmable gate array, FPGA) or another programmable logic device, a discrete gate or a transistor logic device, or a discrete hardware component. The processor 1603 may implement or perform the methods, steps, and logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware and a software module in a decoding processor. The software module may be located in a mature storage medium in the art, such as a random access memory, a flash memory, a read-only memory, a programmable read-only memory, an electrically erasable programmable memory, or a register. The storage medium is located in the memory 1604, and the processor 1603 reads information in the memory 1604 and completes the steps in the foregoing methods in combination with hardware of the processor 1603.

The receiver 1601 may be configured to: receive input digital or character information, and generate a signal input related to function control and related setting of the execution device. The transmitter 1602 may be configured to output digital or character information through a first interface. The transmitter 1602 may be further configured to send instructions to a disk group through the first interface, to modify data in the disk group. The transmitter 1602 may further include a display device, for example, a display.

The electronic device provided in this embodiment of this application may be specifically a chip. The chip includes a processing unit and a communication unit. The processing unit may be, for example, a processor, and the communication unit may be, for example, an input/output interface, a pin, or a circuit. The processing unit may execute computer-executable instructions stored in a storage unit, so that a chip in the execution device performs the model hyperparameter selection method described in the foregoing embodiments, or a chip in a training device performs the model hyperparameter selection method described in the foregoing embodiments. Optionally, the storage unit is a storage unit in the chip, for example, a register or a buffer. Alternatively, the storage unit may be a storage unit in a wireless access device but outside the chip, for example, a read-only memory (read-only memory, ROM), another type of static storage device that can store static information and instructions, or a random access memory (random access memory, RAM).

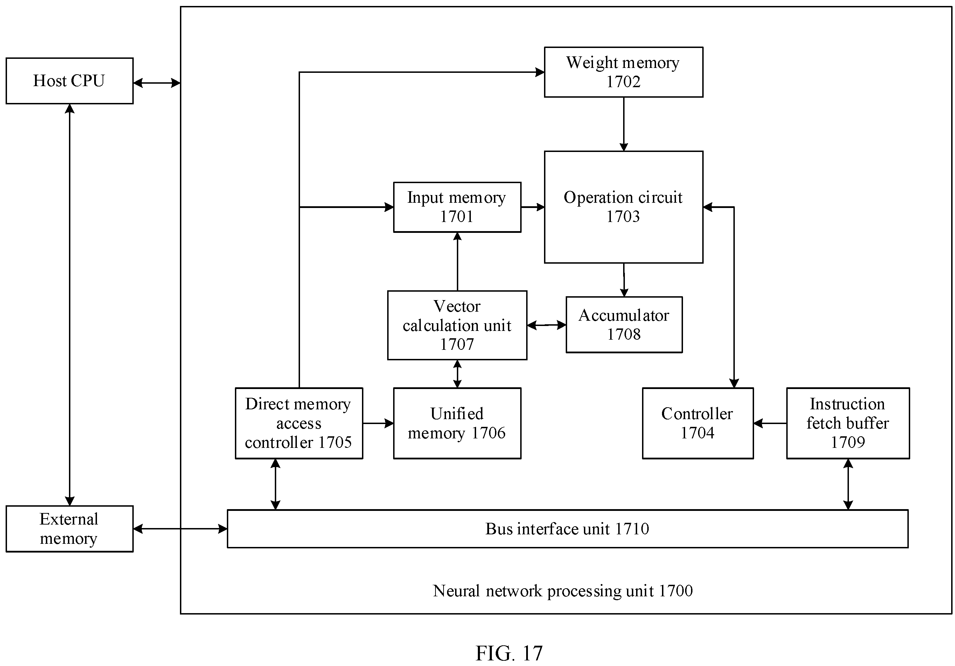

Specifically, FIG. 17 is a diagram of a structure of a chip according to an embodiment of this application. The chip may be represented as a neural network processing unit NPU 1700. The NPU 1700 is mounted to a host CPU (Host CPU) as a coprocessor, and a task is allocated by the host CPU. A core part of the NPU is an operation circuit 1703. A controller 1704 controls the operation circuit 1703 to extract matrix data in a memory and perform a multiplication operation.

In some implementations, the operation circuit 1703 includes a plurality of processing units (Process Engine, PE). In some implementations, the operation circuit 1703 is a two-dimensional systolic array. The operation circuit 1703 may be alternatively a one-dimensional systolic array or another electronic circuit that can perform mathematical operations such as multiplication and addition. In some implementations, the operation circuit 1703 is a general-purpose matrix processor.

For example, it is assumed that there is an input matrix A, a weight matrix B, and an output matrix C. The operation circuit obtains data corresponding to the matrix B from a weight memory 1702, and buffers the data on each PE in the operation circuit. The operation circuit obtains data of the matrix A from an input memory 1701, to perform a matrix operation with the matrix B to obtain a partial result or a final result of a matrix, and stores the result into an accumulator (accumulator) 1708.

A unified memory 1706 is configured to: store input data, and output data. Weight data is directly transferred to the weight memory 1702 through a direct memory access controller (Direct Memory Access Controller, DMAC) 1705. The input data is also transferred to the unified memory 1706 through the DMAC.

A BIU is a bus interface unit, namely, a bus interface unit 1710, and is configured to perform interaction between an AXI bus, and the DMAC and an instruction fetch buffer (Instruction Fetch Buffer, IFB) 1709.

The bus interface unit (Bus Interface Unit, BIU) 1710 is used by the instruction fetch buffer 1709 to obtain instructions from an external memory, and is further used by the direct memory access controller 1705 to obtain original data of the input matrix A or the weight matrix B from the external memory.

The DMAC is mainly configured to: transfer input data in the external memory DDR to the unified memory 1706, transfer weight data to the weight memory 1702, or transfer input data to the input memory 1701.

A vector calculation unit 1707 includes a plurality of operation processing units. If necessary, further processing such as vector multiplication, vector addition, an exponential operation, a logarithmic operation, and value comparison is performed on an output of the operation circuit 1703. The vector calculation unit 1707 is mainly used for non-convolutional/fully connected layer network calculation in a neural network, such as batch normalization (batch normalization), pixel-level summation, and upsampling on a feature map.

In some implementations, the vector calculation unit 1707 can store a processed output vector into the unified memory 1706. For example, the vector calculation unit 1707 may apply a linear function or a non-linear function to the output of the operation circuit 1703, for example, perform linear interpolation on a feature map extracted from a convolutional layer, and for another example, accumulate vectors of values to generate an activation value. In some implementations, the vector calculation unit 1707 generates a normalized value, a pixel-level sum value, or both a normalized value and a pixel-level sum value. In some implementations, the processed output vector can be used as an activation input of the operation circuit 1703, for example, may be used at a subsequent layer of the neural network.

The instruction fetch buffer (instruction fetch buffer) 1709 connected to the controller 1704 is configured to store instructions used by the controller 1704.

The unified memory 1706, the input memory 1701, the weight memory 1702, and the instruction fetch buffer 1709 are all on-chip memories. The external memory is private to a hardware architecture of the NPU.

Any one of the processors mentioned above may be a general-purpose central processing unit, a microprocessor, an ASIC, or one or more integrated circuits for controlling program execution.

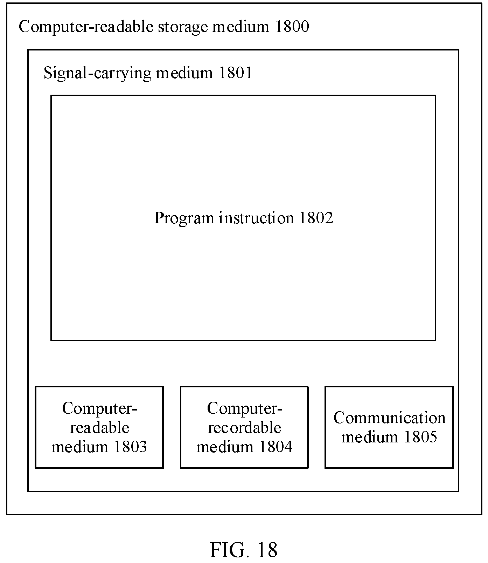

FIG. 18 is a diagram of a structure of a computer-readable storage medium according to an embodiment of this application. This application further provides a computer-readable storage medium. In some embodiments, the method disclosed in FIG. 3 may be implemented as computer program instructions encoded in a machine-readable format on the computer-readable storage medium or encoded in another non-transitory medium or product.

FIG. 18 schematically shows a conceptual partial view of an example computer-readable storage medium arranged according to at least some embodiments shown herein. The example computer-readable storage medium includes a computer program for executing a computer process on a computing device.

In an embodiment, a computer-readable storage medium 1800 is provided by using a signal-carrying medium 1801. The signal-carrying medium 1801 may include one or more program instructions 1802. When the program instructions are run by one or more processors, the functions or some of the functions described in FIG. 4 or FIG. 5 may be provided.

In some examples, the signal-carrying medium 1801 may include a computer-readable medium 1803, for example but not limited to a hard disk drive, a compact disc (CD), a digital video disc (DVD), a digital tape, a memory, a ROM, or a RAM.

In some implementations, the signal-carrying medium 1801 may include a computer-recordable medium 1804, for example but not limited to a memory, a read/write (R/W) CD, or an R/W DVD. In some implementations, the signal-carrying medium 1801 may include a communication medium 1805, for example but not limited to a digital and/or analog communication medium (for example, an optical fiber, a waveguide, a wired communication link, or a wireless communication link). Therefore, for example, the signal-carrying medium 1801 may be delivered by using the communication medium 1805 in a wireless form (for example, a wireless communication medium that complies with the IEEE 802.11 standard or another transmission protocol).

The one or more program instructions 1802 may be, for example, computer-executable instructions or logic implementation instructions. In some examples, the computing device may be configured to provide various operations, functions, or actions in response to the program instructions 1802 transmitted to the computing device through one or more of the computer-readable medium 1803, the computer-recordable medium 1804, and/or the communication medium 1805.

In addition, it should be noted that the apparatus embodiments described above are only examples. The units described as separate parts may or may not be physically separate, and parts displayed as units may or may not be physical units, may be located in one location, or may be distributed on a plurality of network units. Some or all the modules may be selected according to actual needs to achieve the objectives of the solutions of embodiments. In addition, in the accompanying drawings of the apparatus embodiments provided by this application, connection relationships between modules indicate that the modules have communication connections with each other, and may be specifically implemented as one or more communication buses or signal cables.

Based on descriptions of the foregoing implementations, a person skilled in the art may clearly understand that this application may be implemented by software in addition to necessary universal hardware, or by dedicated hardware, including a dedicated integrated circuit, a dedicated CPU, a dedicated memory, a dedicated component, and the like. Generally, any functions that can be performed by a computer program can be easily implemented by using corresponding hardware. Moreover, a specific hardware structure used to achieve a same function may be in various forms, for example, in a form of an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The computer software product is stored in a readable storage medium, such as a floppy disk, a USB flash drive, a removable hard disk, a ROM, a RAM, a magnetic disk, or an optical disc of a computer, and includes several instructions for instructing a computer device (which may be a personal computer, a training device, or a network device) to perform the methods described in embodiments of this application.

All or some of the foregoing embodiments may be implemented by using software, hardware, firmware, or any combination thereof. When software is used to implement the foregoing embodiments, all or some of the foregoing embodiments may be implemented in a form of a computer program product.

The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, a computer, a training device, or a data center to another website, computer, training device, or data center in a wired (for example, a coaxial cable, an optical fiber, or a digital subscriber line (DSL)) or wireless (for example, infrared, radio, or microwave) manner. The computer-readable storage medium may be any usable medium that can be stored by the computer, or a data storage device, such as a training device or a data center, integrating one or more usable media. The usable medium may be a magnetic medium (for example, a floppy disk, a hard disk drive, or a magnetic tape), an optical medium (for example, a DVD), a semiconductor medium (for example, a solid state disk (Solid State Disk, SSD)), or the like.

**Claims**

1. A battery performance prediction method, comprising:

   obtaining a first stage parameter of a battery, wherein the first stage parameter comprises a parameter of the battery in a procedure of undergoing a first stage process;
   processing the first stage parameter by using a first network, to obtain a second stage result of the battery, wherein the second stage result is obtained based on a second stage parameter, the second stage parameter is a parameter that is predicted by the first network and that is of the battery in a procedure of undergoing a second stage process, and the second stage process is performed after the first stage process; and
   obtaining, through prediction, a performance parameter of the battery based on the first stage parameter and the second stage result by using a second network.

2. The method according to claim **1,** wherein the first stage process comprises a battery production process, the second stage process comprises a battery capacity grading process, and the performance parameter comprises a battery capacity; or
   the first stage process comprises a first test of an open circuit voltage OCV, the second stage process comprises a second test of the OCV, and the performance parameter comprises a battery self-discharge rate.

3. The method according to claim 1 or 2, wherein the second stage result is the second stage parameter obtained by the first network through prediction, and the second stage parameter is the parameter of the battery in the procedure of undergoing the second stage process.

4. The method according to claim 1 or 2, wherein the obtaining, through prediction, a performance parameter of the battery based on the first stage parameter and the second stage result by using a second network comprises:

   processing the first stage parameter by using a feature extraction layer in the second network, to obtain a first feature; and
   performing fusion processing on the first feature and a second feature by using a feature fusion layer in the second network, to obtain the performance parameter of the battery through prediction, wherein
   the second feature is the second stage result output by a feature extraction layer in the first network.

5. The method according to claim 1 or 2, wherein the method further comprises:

   performing feature extraction on the first stage parameter by using a third network, to obtain a first feature;
   the processing the first stage parameter by using a first network comprises:

      processing the first feature by using the first network, to obtain the second stage result, wherein the second stage result is a second feature output by a feature extraction layer in the first network; and

the obtaining, through prediction, a performance parameter of the battery based on the first stage parameter and the second stage result by using a second network comprises:

performing fusion processing on the first feature and the second feature by using the second network, to obtain the performance parameter of the battery through prediction.

6. The method according to any one of claims 1 to 5, wherein the first network is specifically configured to predict N target parameters of the battery in the procedure of undergoing the second stage process; and

the battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to **1,** and N is less than or equal to M.

7. The method according to claim 6, wherein the method further comprises:

obtaining a regression model, wherein the regression model represents a relationship between the performance parameter of the battery, and the parameter of the battery in the procedure of undergoing the first stage process and the parameter of the battery in the procedure of undergoing the second stage process;

obtaining, based on the regression model, a degree of contribution of each of the M parameters to the prediction of the performance parameter of the battery; and

determining the N target parameters from the M parameters based on the degree of contribution of each parameter to the prediction of the performance parameter of the battery.

8. The method according to claim 7, wherein the regression model is a linear mathematical model or a neural network model.

9. A model training method, comprising:

obtaining a training data set, wherein the training data set comprises a first stage parameter, a second stage parameter, and a performance parameter that are of a same battery, the first stage parameter comprises a parameter of the battery in a procedure of undergoing a first stage process, and the second stage parameter comprises a parameter of the battery in a procedure of undergoing a second stage process;

processing the first stage parameter by using a first network, to obtain a second stage prediction parameter of the battery, wherein the second stage parameter is a parameter that is obtained by the first network through prediction and that is of the battery in the procedure of undergoing the second stage process;

obtaining a performance prediction parameter of the battery by using a second network based on the first stage parameter and an output result of the first network, wherein the output result of the first network is obtained based on the second stage prediction parameter; and

updating the first network and the second network based on a first loss function and a second loss function, wherein

the first loss function represents a difference between the second stage parameter and the second stage prediction parameter, and the second loss function represents a difference between the performance parameter of the battery and the performance prediction parameter.

10. The method according to claim 9, wherein the first stage process comprises a battery production process, and the second stage process comprises a battery capacity grading process; or

the first stage process comprises a first test of an OCV, and the second stage process comprises a second test of the OCV

11. The method according to claim 9 or 10, wherein the output result of the first network is the second stage prediction parameter obtained by the first network through prediction.

12. The method according to claim 9 or 10, wherein the obtaining a performance prediction parameter of the battery by using a second network based on the first stage parameter and an output result of the first network comprises:

processing the first stage parameter by using a feature extraction layer in the second network, to obtain a first feature; and

performing fusion processing on the first feature and a second feature by using a feature fusion layer in the second network, to obtain the performance prediction parameter of the battery, wherein
the second feature is an output result of a feature extraction layer in the first network.

13. The method according to claim 12, wherein the method further comprises:

extracting a third feature corresponding to the second stage parameter of the battery; and
updating the first network based on a third loss function, wherein the third loss function represents a difference between the second feature and the third feature.

14. The method according to claim 9 or 10, wherein the method further comprises:

performing feature extraction on the first stage parameter by using a third network, to obtain a first feature;
the processing the first stage parameter by using a first network comprises:

processing the first feature by using the first network, to obtain a second feature output by a feature extraction layer in the first network; and
the obtaining a performance prediction parameter of the battery by using a second network based on the first stage parameter and an output result of the first network comprises:
performing fusion processing on the first feature and the second feature by using the second network, to obtain the performance prediction parameter of the battery.

15. The method according to any one of claims 9 to 14, wherein the first network is specifically configured to predict N target parameters of the battery in the procedure of undergoing the second stage process; and
the battery corresponds to a total of M parameters in the procedure of undergoing the second stage process, the N target parameters are N parameters that are in the M parameters and that have a largest degree of contribution to the prediction of the performance parameter of the battery, both M and N are integers greater than or equal to 1, and N is less than or equal to M.

16. The method according to claim 15, wherein the method further comprises:

obtaining a regression model, wherein the regression model represents a relationship between the performance parameter of the battery, and the parameter of the battery in the procedure of undergoing the first stage process and the parameter of the battery in the procedure of undergoing the second stage process;
obtaining, based on the regression model, a degree of contribution of each of the M parameters to the prediction of the performance parameter of the battery; and
determining the N target parameters from the M parameters based on the degree of contribution of each parameter to the prediction of the performance parameter of the battery.

17. The method according to claim 16, wherein the regression model is a linear mathematical model or a neural network model.

18. A battery performance prediction apparatus, comprising:

an obtaining module, configured to obtain a first stage parameter of a battery, wherein the first stage parameter comprises a parameter of the battery in a procedure of undergoing a first stage process; and
a processing module, configured to process the first stage parameter by using a first network, to obtain a second stage result of the battery, wherein the second stage result is obtained based on a second stage parameter, the second stage parameter is a parameter that is predicted by the first network and that is of the battery in a procedure of undergoing a second stage process, and the second stage process is performed after the first stage process; and
the processing module is further configured to obtain, through prediction, a performance parameter of the battery based on the first stage parameter and the second stage result by using a second network.

19. The apparatus according to claim 18, wherein the first stage process comprises a battery production process, the second stage process comprises a battery capacity grading process, and the performance parameter comprises a battery capacity; or
the first stage process comprises a first test of an OCV, the second stage process comprises a second test of the OCV, and the performance parameter comprises a battery self-discharge rate.

20. The apparatus according to claim 18 or 19, wherein the processing module is specifically configured to:

   process the first stage parameter by using a feature extraction layer in the second network, to obtain a first feature; and
   perform fusion processing on the first feature and a second feature by using a feature fusion layer in the second network, to obtain the performance parameter of the battery through prediction, wherein
   the second feature is the second stage result output by a feature extraction layer in the first network.

21. The apparatus according to claim 18 or 19, wherein the processing module is specifically configured to:

   perform feature extraction on the first stage parameter by using a third network, to obtain a first feature;
   process the first feature by using the first network, to obtain the second stage result, wherein the second stage result is a second feature output by a feature extraction layer in the first network; and
   perform fusion processing on the first feature and the second feature by using the second network, to obtain the performance parameter of the battery through prediction.

22. A model training apparatus, comprising:

   an obtaining module, configured to obtain a training data set, wherein the training data set comprises a first stage parameter, a second stage parameter, and a performance parameter that are of a same battery, the first stage parameter comprises a parameter of the battery in a procedure of undergoing a first stage process, and the second stage parameter comprises a parameter of the battery in a procedure of undergoing a second stage process;
   a processing module, configured to process the first stage parameter by using a first network, to obtain a second stage prediction parameter of the battery, wherein the second stage parameter is a parameter that is obtained by the first network through prediction and that is of the battery in the procedure of undergoing the second stage process, and
   the processing module is further configured to obtain a performance prediction parameter of the battery by using a second network based on the first stage parameter and an output result of the first network, wherein the output result of the first network is obtained based on the second stage prediction parameter; and
   an updating module, configured to update the first network and the second network based on a first loss function and a second loss function, wherein
   the first loss function represents a difference between the second stage parameter and the second stage prediction parameter, and the second loss function represents a difference between the performance parameter of the battery and the performance prediction parameter.

23. The apparatus according to claim 22, wherein the first stage process comprises a battery production process, and the second stage process comprises a battery capacity grading process; or
   the first stage process comprises a first test of an open circuit voltage OCV, and the second stage process comprises a second test of the OCV.

24. The apparatus according to claim 22 or 23, wherein the processing module is specifically configured to:

   process the first stage parameter by using a feature extraction layer in the second network, to obtain a first feature; and
   perform fusion processing on the first feature and a second feature by using a feature fusion layer in the second network, to obtain the performance prediction parameter of the battery, wherein
   the second feature is an output result of a feature extraction layer in the first network.

25. The apparatus according to claim 22 or 23, wherein the processing module is specifically configured to:

   perform feature extraction on the first stage parameter by using a third network, to obtain a first feature;
   process the first feature by using the first network, to obtain a second feature output by a feature extraction layer in the first network; and
   perform fusion processing on the first feature and the second feature by using the second network, to obtain the performance prediction parameter of the battery.

26. A battery performance prediction apparatus, comprising a memory and a processor, wherein the memory stores code, the processor is configured to execute the code, and when the code is executed, the apparatus performs the method according to any one of claims 1 to 8.

27. A model training apparatus, comprising a memory and a processor, wherein the memory stores code, the processor is configured to execute the code, and when the code is executed, the apparatus performs the method according to any one of claims 9 to 17.

28. A computer storage medium, wherein the computer storage medium stores instructions, and when the instructions are executed by a computer, the computer is enabled to perform the method according to any one of claims 1 to 17.

29. A computer program product, wherein the computer program product stores instructions, and when the instructions are executed by a computer, the computer is enabled to perform the method according to any one of claims 1 to 17.

Neural
network
layer 130

Output layer
140

Hidden layer n
13n

Hidden layer 2
132

Hidden layer 1
131

126

125

124

123

122

121

Convolutional
layer/Pooling
layer 120

Convolutional
neural
network
(CNN) 100

Input layer
110

Input layer
110

To-be-processed
image

FIG. 1

Output layer
140

Hidden layer n
13n

Hidden layer 2
132

Hidden layer 1
131

Neural
network
layer 130

Convolutional
neural network
(CNN) 100

| 126 | 126 | 126 |
| 125 | 125 | 125 |
| 124 | 124 | 124 |
| 123 | 123 | 123 |
| 122 | 122 | 122 |
| 121 | 121 | 121 |

Convolutional
layer/Pooling
layer 120

Input layer
110

Input layer
110

To-be-processed
image

FIG. 2

FIG. 3

Obtain a training data set, where the training data set includes a first stage parameter, a second stage parameter, and a performance parameter that are of a same battery

401

Process the first stage parameter by using a first network, to obtain a second stage prediction parameter of the battery, where the second stage prediction parameter is a parameter that is obtained by the first network through prediction and that is of the battery in a procedure of undergoing a second stage process

402

Obtain a performance prediction parameter of the battery by using a second network based on the first stage parameter and an output result of the first network, where the output result of the first network is obtained based on the second stage prediction parameter

403

Update the first network and the second network based on a first loss function and a second loss function

404

FIG. 4

Obtain a first stage parameter of a battery, where the first stage parameter includes a parameter of the battery in a procedure of undergoing a first stage process

501

Process the first stage parameter by using a first network, to obtain a second stage result of the battery, where the second stage result is obtained based on a second stage parameter, the second stage parameter is a parameter that is predicted by the first network and that is of the battery in a procedure of undergoing a second stage process, and the second stage process is performed after the first stage process

502

Obtain, through prediction, a performance parameter of the battery by using a second network based on the first stage parameter and the second stage result

503

FIG. 5

Model training phase

FIG. 6

Model inference phase

FIG. 7

Model training phase

FIG. 8

EP 4 624 957 A1

FIG. 9

Model inference phase

FIG. 10

Model training phase

FIG. 11

EP 4 624 957 A1

Model training phase

FIG. 12

EP 4 624 957 A1

| Formation voltages 1 to 3 |
| --- |
| Formation temperatures 1 to 3 |
| Amount of electrolyte filled at a time |
| Open circuit voltage |
| Open circuit resistance |
| DCIR |
| Roll core weight |

Training data set

Battery production parameter

Capacity grading stage parameter

Capacity prediction network

Actual battery capacity

Predicted battery capacity

Loss function

| States of charge 1 to N |
| --- |
| Voltages 1 to N |
| Temperatures 1 to N |

After training is complete, output degrees of contribution of capacity grading stage parameters to prediction of a battery capacity

| State of charge 1 | X1 |
| --- | --- |
| ... | ... |
| Voltage 1 | Y1 |
| ... | ... |
| Temperature 1 | Z1 |
| ... | ... |

Select K capacity grading stage parameters with a largest degree of contribution

| State of charge... |
| --- |
| Voltage... |
| Temperature... |

FIG. 13

Battery performance prediction apparatus

/ 1401         / 1402

| Obtaining module | Processing module |

FIG. 14

Model training apparatus

/ 1501     / 1502     / 1503

| Obtaining module | Processing module | Updating module |

FIG. 15

1600

Execution device

Antenna                   Antenna

| Receiver 1601 | Transmitter 1602 |

Processor 1603

| Memory 1604 | Application processor 16031 | Communication processor 16032 |

FIG. 16

FIG. 17

Computer-readable storage medium 1800

Signal-carrying medium 1801

Program instruction 1802

| Computer-readable medium 1803 | Computer-recordable medium 1804 | Communication medium 1805 |

FIG. 18

# INTERNATIONAL SEARCH REPORT

| International application No. |
|---|
| **PCT/CN2023/142194** |

| **A.** | **CLASSIFICATION OF SUBJECT MATTER** |
|---|---|

G01R31/385(2019.01)i; G01R31/367(2019.01)i; G06Q10/04(2023.01)i; G06N3/08(2023.01)i; H01M10/48(2006.01)i

According to International Patent Classification (IPC) or to both national classification and IPC

| **B.** | **FIELDS SEARCHED** |
|---|---|

Minimum documentation searched (classification system followed by classification symbols)

IPC:G01R G06Q G06N H01M

Documentation searched other than minimum documentation to the extent that such documents are included in the fields searched

Electronic data base consulted during the international search (name of data base and, where practicable, search terms used)

CNTXT; CNABS; ENTXT; WPABS; ENTXTC; CNKI; IEEE: 华为, 叶君健, 郑嘉乐, 张可力, 潘璐伽, 李林福, 电池, 性能, 预测, 生产, 分容, 开路电压, 自放电, 容量, 速率, 模型, 获取, 处理, 网络, 特征, 提取, 函数, batter+, cell?, performance, predict+, ocv, discharg+, capacit+, speed, model, former, function

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| PX | CN 116047330 A (HUAWEI TECHNOLOGIES CO., LTD.) 02 May 2023 (2023-05-02) claims 1-29 | 1-29 |
| X | CN 115166532 A (WUHAN POWER BATTERY REGENERATION TECHNOLOGY CO., LTD. et al.) 11 October 2022 (2022-10-11) description, paragraphs [0006]-[0110] | 1, 18, 26, 28, 29 |
| A | CN 113687250 A (SVOLT ENERGY TECHNOLOGY CO., LTD.) 23 November 2021 (2021-11-23) entire document | 1-29 |
| A | CN 113406496 A (GUANGZHOU HKUST FOK YING TUNG RESEARCH INSTITUTE) 17 September 2021 (2021-09-17) entire document | 1-29 |
| A | CN 111965545 A (SVOLT ENERGY TECHNOLOGY CO., LTD.) 20 November 2020 (2020-11-20) entire document | 1-29 |

| ✓ | Further documents are listed in the continuation of Box C. | ✓ | See patent family annex. |
|---|---|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **29 February 2024** | **17 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/142194** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2021050631 A1 (IBM) 18 February 2021 (2021-02-18)<br>entire document | 1-29 |

Form PCT/ISA/210 (second sheet) (July 2022)

**INTERNATIONAL SEARCH REPORT**
Information on patent family members

| International application No. |
| --- |
| **PCT/CN2023/142194** |

| Patent document cited in search report | | | Publication date (day/month/year) | Patent family member(s) | | | Publication date (day/month/year) |
| --- | --- | --- | --- | --- | --- | --- | --- |
| CN | 116047330 | A | 02 May 2023 | None | | | |
| CN | 115166532 | A | 11 October 2022 | None | | | |
| CN | 113687250 | A | 23 November 2021 | None | | | |
| CN | 113406496 | A | 17 September 2021 | None | | | |
| CN | 111965545 | A | 20 November 2020 | None | | | |
| US | 2021050631 | A1 | 18 February 2021 | US | 10957946 | B2 | 23 March 2021 |

Form PCT/ISA/210 (patent family annex) (July 2022)

**EP 4 624 957 A1**

**Patent documents cited in the description**

- CN 202211668929